# EUROPÄISCHE PATENTSCHRIFT

(11) **EP 3 964 832 B1**
(45) Veröffentlichungstag und Bekanntmachung des Hinweises auf die Patenterteilung: **25.11.2026**
(21) Anmeldenummer: 21194073.9
(22) Anmeldetag: 31.08.2021
(51) Int. Cl.: G01N 29/50, G01F 1/66, G01F 1/667, G01N 29/24, G01N 29/32, G01N 29/44

(54) **MESSVERFAHREN UND MESSANORDNUNG ZUR ENTSTÖRUNG EINES EMPFANGSSIGNALS EINES EMAT-WANDLERS**
MEASURING METHOD AND MEASURING ARRANGEMENT FOR INTERFERENCE SUPPRESSION OF A RECEIVED SIGNAL OF AN EMAT CONVERTER
PROCÉDÉ DE MESURE ET AGENCEMENT DE MESURE DESTINÉS À LA SUPPRESSION DES INTERFÉRENCES D'UN SIGNAL DE RÉCEPTION D'UN TRANSDUCTEUR EMAT

(30) Priorität: 03.09.2020 DE 102020123072
(43) Veröffentlichungstag der Anmeldung: 09.03.2022
(73) Patentinhaber: Rosenxt Holding AG, 6370 Stans (CH)
(72) Erfinder: BLUMENSTEIN, Eduard, 49809 Lingen (DE); SCHEMMANN, Marcel, 6105 BN Maria-Hoop (NL)
(74) Vertreter: Wischmeyer, André

(56) Entgegenhaltungen:
- DE-A1- 102010 006 275
- DE-A1- 102018 122 584
- US-A- 4 307 616
- US-A- 5 581 037

## Beschreibung

Die Erfindung betrifft ein Messverfahren an einem elektrisch leitfähigen Objekt, insbesondere an einer Pipeline, wobei mittels eines an oder nahe einer Oberfläche des Objekts positionierten ersten EMAT-Sendewandlers einer Messanordnung, der eine zumindest eine Leiterbahn aufweisende erste Sendewandler-Induktionsspule aufweist, eine erste Ultraschallwelle in dem Objekt erzeugt wird und ein an oder nahe der Oberfläche des Objekts positionierter erster EMAT-Empfangswandler der Messanordnung, der eine zumindest eine Leiterbahn aufweisende erste Empfangswandler-Induktionsspule aufweist, ein erstes Empfangssignal detektiert, wobei das erste Empfangssignal ein sich zumindest teilweise aus der ersten Ultraschallwelle, die sich durch zumindest einen Teil des Objekts ausgebreitet hat, ergebendes erstes Ultraschallsignal und ein erstes elektro-magnetisches Störsignal umfasst. Des Weiteren betrifft die Erfindung eine Messanordnung zur Durchführung eines solchen Messverfahrens.

EMAT-Wandler werden in diversen Industriezweigen bei zerstörungsfreien Prüf- und Messverfahren eingesetzt. Ein Vorteil dieser Technologie ist, dass akustische Wellen in einem leitfähigen Objekt kontaktlos, d.h. ohne eine akustische Kopplung mittels eines Kopplungsmediums, erzeugt werden können. Aus diesem Grund eignen sich EMAT-Wandler besonders für den Einsatz unter raueren Betriebsbedingungen, etwa wenn am Objekt besonders hohe oder niedrige Temperaturen vorliegen.

Die Funktionsweise von EMAT-Wandlern basiert auf einem Zusammenspiel einer Induktionsspule mit einem Magneten. Der Magnet, der als Permanentmagnet oder Elektromagnet ausgeführt sein kann, magnetisiert einen Teil der Oberfläche des leitfähigen Objekts. Wird die Induktionsspule mit einem Wechselstrom angetrieben, erzeugt sie ein Wechselstrommagnetfeld, welches Wirbelströme in dem leitenden Objekt erzeugt, die wiederum mit dem Magnetfeld des Magneten wechselwirken. Das Magnetfeld kann ein statisches Magnetfeld eines Permanentmagneten oder ein quasi-statisches Magnetfeld eines Elektromagneten sein, der mit einer weit niedrigeren Frequenz angetrieben wird als die Induktionsspule. In Abhängigkeit des die Induktionsspule antreibenden Wechselstroms wird in dem Objekt eine Ultraschallwelle erzeugt, z.B. in Form eines einzelnen Ultraschallpulses, d.h. eines mehrere, beispielsweise sinusförmige Oszillationen umfassenden Wellenpakets, oder in Form einer Sequenz von Ultraschallpulsen, die allgemein als "Pulsburst" bezeichnet wird.

Bei der Detektion verläuft dieser Wechselwirkungsprozess in entgegengesetzter Richtung: Die Ultraschallwelle, die sich durch zumindest einen Teil des Objekts ausgebreitet hat, wechselwirkt mit dem statischen oder quasi-statischen Magnetfeld des EMAT-Empfangswandlers und erzeugt Wirbelströme in dem Objekt, die wiederum ein magnetisches Wechselfeld erzeugen, das in der Induktionsspule ein Ultraschallsignal induziert. Aus diesem Ultraschallsignal können Informationen über das Objekt, wie beispielsweise Spannungskorrosionsrisse oder Fehlstellen in einer Beschichtung des Objekts, sowie ggf. auch Eigenschaften eines durch das Objekt strömenden Mediums, z.B. dessen Durchflussrate, bestimmt werden.

Sowohl für die Erzeugung als auch die Detektion von Ultraschallwellen genügt es, wenn die EMAT-Wandler derart nah einer Oberfläche des Objekts positioniert sind, dass die Felder der EMAT-Wandler noch auf das Objekt oder eine Wandung des Objekts einwirken, d.h. dort Ultraschallwellen erzeugen oder detektieren können. Ein direkter Kontakt zwischen den EMAT-Wandlern und dem Objekt ist hierzu nicht notwendig.

In die Induktionsspule des EMAT-Empfangswandlers, der in der Regel von dem Objekt, an dem gemessen wird, galvanisch getrennt ist, koppeln neben dem das eigentliche Nutzsignal darstellenden Ultraschallsignal auch elektro-magnetische Störsignale. Das Empfangssignal wird durch diese Störsignale verrauscht.

So treten etwa bei Messungen der Durchflussrate eines durch eine Pipeline strömenden Mediums Störungen auf, die durch Störquellen, wie beispielsweise Motoren oder Frequenzumrichter, erzeugt werden und sich durch die Pipelinewand über große Distanzen ausbreiten. Diese Störungen können als Störsignale in das Messsystem einkoppeln. Des Weiteren kann auch eine Potentialdifferenz zwischen dem Messsystem und dem davon in der Regel galvanisch getrennten sowie geerdeten Objekt ebenfalls als weiteres Störsignal in das Messsystem einkoppeln. Insgesamt führen die auftretenden Störsignale zu einem verschlechterten Signal-Rausch-Verhältnis, so dass Informationen über das Objekt sowie ggf. auch Eigenschaften eines durch das Objekt strömenden Mediums nicht optimal bestimmt werden können.

Es sind verschiedene Methoden vorbekannt, das Signal-Rausch-Verhältnis zu verbessern:
In der DE 10 2010 006 275 A1 ist ein Verfahren zur Prüfung eines metallischen Prüfobjekts mittels eines elektromagnetisch-akustischen Wandlers offenbart. Hierbei wird in einem ersten Schritt in einem Bereich des Prüfobjekts ein erstes Magnetfeld mit einer ersten Flussdichte erzeugt und mit dem elektromagnetisch-akustischen Wandler eine Messung eines ersten Antwortsignals durchgeführt. Anschließend wird in einem zweiten Schritt in demselben Bereich des Prüfobjekts ein zweites Magnetfeld mit einer zweiten Flussdichte erzeugt und mit dem elektromagnetisch-akustischen Wandler eine Messung eines zweiten Antwortsignals durchgeführt. Durch Korrelation des ersten und zweiten Antwortsignals wird ein Störsignal eliminiert.

Weiterhin ist in der DE 10 2018 122 584 A1 ein Verfahren zur nichtinvasiven Bestimmung des Flusses oder der Durchflussrate in einem von einem gasförmigen Medium durchströmten, elektrisch leitenden Objekt mittels eines akustischen Durchflussmessers offenbart, bei dem in der Analyse eines Nutzsignals ein Nebenkeulensignal verwendet wird, welches sich in der Objektwand ausbreitet. Das Nutzsignal kann dabei unter Verwendung des Nebenkeulensignals entstört werden.

Die US 5,581,037 schlägt die Verwendung zweier Empfangsspulen vor, die um eine halbe Wellenlänge der im untersuchten Objekt erzeugten Schallwellen versetzt zueinander angeordnet sind. Die Ausgänge diese Spulen werden in einem Differenzsignalverstärker verarbeite. Dieser invertiert einen der Eingänge und addiert den invertierten und den nicht-invertierten Eingang. Elektromagnetische Störsignale werden hierdurch zumindest teilweise eliminiert, während sich die Signale aufgrund der Schallwellen verdoppelt werden.

Aufgabe der vorliegenden Erfindung ist es, ein EMAT-basiertes Messverfahren und eine EMAT-basierte Messanordnung mit verbessertem Signal-Rausch-Verhältnis bereitzustellen.

Diese Aufgabe wird durch ein Messverfahren nach dem Anspruch 1 gelöst. Ferner wird die Aufgabe durch eine Messanordnung gemäß Anspruch 17 gelöst. Vorteilhafte Weiterbildungen der Erfindung sind den auf den jeweiligen Anspruch rückbezogenen Unteransprüchen sowie der nachfolgenden Beschreibung zu entnehmen.

Das erfindungsgemäße Verfahren zeichnet sich durch folgende Schritte aus:
- Detektion eines zumindest ein zweites elektro-magnetisches Störsignal umfassenden zweiten Empfangssignals, während das erste Empfangssignal vom E-MAT-Wandler detektiert wird, mittels eines ersten Empfangsmittels der Messanordnung,
- Detektion eines insbesondere vom zweiten Empfangssignal verschiedenen, zumindest ein drittes elektro-magnetisches Störsignal umfassenden dritten Empfangssignals, während das erste Empfangssignal vom ersten EMAT-Empfangswandler detektiert wird, mittels eines vom ersten Empfangsmittel verschiedenen, zweiten Empfangsmittels der Messanordnung, wobei das dritte elektro-magnetische Störsignal ein Spulen-Störsignal oder ein Erdungs-Störsignal ist,
- gemeinsame Verarbeitung zumindest des dritten Empfangssignals mit dem ersten Empfangssignal und dem zweiten Empfangssignal in der Entstörungsoperation mittels des Entstörungsmittels der Messanordnung, wobei zumindest das erste Empfangssignal zumindest teilweise entstört wird.

Zur Entstörung des ersten Empfangssignals werden somit zumindest zwei weitere, sich voneinander unterscheidende Empfangssignale detektiert. Dabei ist das zweite Störsignal ein Spulen-Störsignal und das dritte Störsignal ein Erdungs-Störsignal oder das zweite Störsignal ein Erdungs-Störsignal und das dritte Störsignal ein Spulen-Störsignal. Ansonsten gilt für das zweite Empfangsmittel, das dritte Empfangssignal sowie das dritte Störsignal das in der gesamten Anmeldung für das erste Empfangsmittel, das zweite Empfangssignal sowie das zweite Störsignal beschriebene entsprechend. Auf diese Weise werden zwei Arten der Störung, d.h. sowohl das Spulen-Störsignal als auch das Erdungs-Störsignal, zur Entstörung des ersten Empfangssignals verwendet, was zu einem verbesserten Signal-Rausch-Verhältnis führt.

Als Entstörungsoperation wird eine Operation bezeichnet, bei der zumindest das erste Empfangssignal, das zweite Empfangssignal und das dritte Empfangssignal gemeinsam verarbeitet werden, woraufhin sich im ersten Empfangssignal das Verhältnis von dem ersten Ultraschallsignal zu dem ersten Störsignal verbessert, d.h. der Anteil des ersten Störsignals am ersten Empfangssignal abnimmt. So kann beispielsweise eine Subtraktion des ggf. mit einem Faktor multiplizierten zweiten Empfangssignals vom ersten Empfangssignal eine solche Entstörungsoperation darstellen. Jedoch können auch andere Operationen zur Rauschunterdrückung verwendet werden, sofern sie der vorgenannten Definition einer Entstörungsoperation entsprechen.

Vorzugsweise umfasst die Messanordnung eine Steuer- und Auswerteeinheit, die die EMAT-Wandler ansteuert und ausliest sowie die empfangenen Signale auswertet. Insbesondere kann das Entstörungsmittel in die Steuer- und Auswerteeinheit, beispielsweise in Form einer auf der Steuer- und Auswerteeinheit laufenden Software, integriert sein.

In einer bevorzugten Ausgestaltung der Erfindung wird das zweite Empfangssignal von einer an oder nahe der Oberfläche des Objekts positionierten und zumindest eine Leiterbahn aufweisenden Empfangsmittel-Spule des ersten Empfangsmittels detektiert. Ein mit einer zur ersten Empfangswandler-Induktionsspule separaten Induktionsspule aufgezeichnetes Störsignal wird im Folgenden als Spulen-Störsignal bezeichnet. Bei dieser Ausgestaltung werden sowohl das erste Störsignal als auch das zweite Störsignal mittels einer Induktionsspule detektiert, wodurch sich die Störsignale weitgehend ähneln. Auf diese Weise kann eine besonders zuverlässige Entstörungsoperation, beispielsweise durch Subtraktion des zweiten Empfangssignals vom ersten Empfangssignal, erreicht werden. Besonders vorteilhaft ist es, wenn die zur Detektion des zweiten Empfangssignals verwendete Empfangsmittel-Induktionsspule zumindest im Wesentlichen baugleich zur ersten Empfangswandler-Induktionsspule ist, z.B. gleiche äußere Abmessungen und die gleiche Anzahl an Wicklungen aufweist. Bei einer solchen Ausführungsform sind das erste Störsignal und das zweite Störsignal weitestgehend ähnlich, insbesondere nahezu identisch, was eine noch zuverlässigere Entstörungsoperation ermöglicht.

Gemäß einer weiteren bevorzugten Ausgestaltung der Erfindung wird als Empfangsmittel-Induktionsspule zur Detektion des zweiten Empfangssignals die erste Sendewandler-Induktionsspule oder eine weitere, von der Empfangswandler-Induktionsspule verschiedene Induktionsspule der Messanordnung verwendet. Da sich Schall durch das leitendes Objekt in der Regel um Größenordnungen langsamer ausbreitet als ein elektro-magnetisches Signal, sind diverse Wandler-Konfigurationen möglich, bei denen der Abstand zwischen dem Empfangswandler und einem weiteren Wandler der Messanordnung so bemessen ist, dass dann, wenn der Empfangswandler ein Ultraschallsignal aufzeichnet, an dem weiteren Wandler, beispielsweise an dem mit dem Empfangswandler zugeordneten Sendewandler oder auch einem Wandler eines weiteren Sender-Empfänger-Paares der Messanordnung, kein oder nahezu kein Ultraschallsignal vorliegt. In diesem Fall kann die Induktionsspule dieses weiteren Wandlers als Empfangsmittel verwendet werden. Auf diese Weise wird zur Detektion des für die Entstörungsoperation verwendeten zweiten Störsignals auf bereits vorhandene Komponenten der Messanordnung zurückgegriffen. Dadurch kann eine Entstörung besonders einfach und kostengünstig erreicht werden. Des Weiteren kann das verbesserte Messverfahren auch auf bestehenden Systemen in einfacher Weise implementiert werden.

In einer weiteren vorteilhaften Ausgestaltung der Erfindung wird das zweite Empfangssignal mittels einer mit dem Objekt oder einem geerdeten Gehäuseteil eines die Messanordnung schützenden Gehäuses elektrisch leitfähigen verbundenen oder in sonstiger Weise geerdeten Leitung der Messanordnung als erstes Empfangsmittel detektiert. Ein mit einer solchen Leitung separat gemessenes Störsignal wird im Folgenden als Erdungs-Störsignal bezeichnet. Auf diese Weise kann insbesondere ein Störsignal, das von einer Potentialdifferenz zwischen dem EMAT-System und dem in der Regel geerdeten Objekt herrührt, separat aufgezeichnet und zur Verbesserung des Signal-Rausch-Verhältnisses in der Entstörungsoperation verarbeitet werden. Da für die das Rauschen bewirkende Potentialdifferenz das Erdpotential ein Bezugspunkt ist, kann zum Zweck der separaten Detektion des Erdungs-Störsignals ggf. jegliche Art eines geerdeten Kontakts als Empfangsmittel verwendet werden.

Vorzugsweise wird das über die Leitung abgegriffene zweite Empfangssignal in eine Messleitung der Messanordnung unter Beibehaltung einer galvanischen Trennung, insbesondere kapazitiv, eingekoppelt. Auf diese Weise kann das zweite Störsignal detektiert werden, ohne die Potentialdifferenz zwischen dem EMAT-System und dem Objekt und somit das erste Störsignal zu beeinflussen, was negative Auswirkungen auf die Entstörungsoperation und ggf. auch die Ultraschallmessung selbst hätte. Zudem ist dadurch das Verfahren für diejenigen messtechnischen Anwendungen geeignet, bei denen eine galvanische Trennung, etwa aufgrund von Sicherheitsbestimmungen, unbedingt eingehalten werden muss. Das Einkoppeln des zweiten Empfangssignals unter Beibehaltung einer galvanischen Trennung kann beispielsweise durch kapazitive oder induktive Trennung der Messkreise erfolgen.

Gemäß einer weiteren bevorzugten Ausgestaltung der Erfindung werden zumindest das erste Empfangssignal und das zweite Empfangssignal einem analogen und/oder digitalen, elektrischen und/oder elektronischen Bauelement oder einer analogen und/oder digitalen, elektrischen und/oder elektronischen Schaltung als ein Entstörungsmittel zugefügt, insbesondere wobei die Entstörungsoperation zumindest eine Subtraktion der Empfangssignale, bevorzugt eine Subtraktion des zweiten Empfangssignals vom ersten Empfangssignal umfasst. Ein derart ausgebildetes Entstörungsmittel kann in einfacher Weise und kostengünstig implementiert werden.

Besonders vorteilhaft ist dabei die Verwendung einer Gleichtaktdrossel als Entstörungsmittel, bei der das erste Empfangssignal und das zweite Empfangssignal den Eingängen der Gleichtaktdrossel zugeführt und einer induktiven Subtraktion als Entstörungsoperation unterzogen werden. Die Gleichtaktdrossel hat mehrere gleiche Wicklungen, die gegensinnig von den Empfangssignalen durchflossen werden, sodass sich deren magnetische Felder im Kern der Gleichtaktdrossel aufheben. Dabei wird das mit dem ersten Störsignal weitestgehend ähnliche, insbesondere im Wesentlichen identische, zweite Störsignal von dem ersten Empfangssignal subtrahiert, wodurch im Idealfall lediglich das erste Ultraschallsignal im ersten Empfangssignal verbleibt.

Alternativ kann als Entstörungsmittel auch eine Datenverarbeitungsanlage verwendet werden, der das erste Empfangssignal und das zweite Empfangssignal zugeführt werden. Dabei kann die Entstörungsoperation durch eine auf der Datenverarbeitungsanlage laufende Software implementiert werden. Eine solche Datenverarbeitungsanlage kann insbesondere durch eine Steuer- und Auswerteeinheit der Messanordnung ausgebildet werden.

In einer weiteren vorteilhaften Ausgestaltung der Erfindung passieren das erste Empfangssignal und das zweite Empfangssignal eine erste Verstärkerstufe, bevor sie in der Entstörungsoperation verarbeitet werden. Dadurch wird insbesondere bei der Verwendung von Entstörungsmitteln, die induktive Bauelemente, wie z.B. eine Gleichtaktdrossel, aufweisen, die Induktivität in einem insbesondere vor der Verstärkerstufe liegende Sensorbereich der Messanordnung, der zumindest den ersten E-MAT-Sendewandler und den ersten EMAT-Empfangswandler umfasst, nicht erhöht, wodurch das Verfahren auch in explosionsgefährdeten Umgebungen anwendbar ist.

Gemäß einer weiteren bevorzugten Ausgestaltung der Erfindung passieren das erste Empfangssignal und das zweite Empfangssignal eine den Sensorbereich der Messanordnung abschirmende Explosionsschutz-Barriere (EX-Barriere) der Messanordnung, bevor sie in der Entstörungsoperation verarbeitet werden. Insbesondere bei der Verwendung von Entstörungsmitteln, die induktive Bauelemente, wie z.B. eine Gleichtaktdrossel, aufweisen, wird auf diese Weise eine Erhöhung der Induktivität im Sensorbereich verhindert, wodurch das Verfahren auch in explosionsgefährdeten Umgebungen angewendet werden kann. Vorzugsweise werden zur Implementierung der Explosionsschutz-Barriere spannungsbegrenzende Dioden verwendet.

In einer weiteren vorteilhaften Ausgestaltung der Erfindung werden das erste Empfangssignal und das zweite Empfangssignal, insbesondere vor der Entstörungsoperation, einer Korrelationsanalyse unterzogen, wobei eine Korrelation, insbesondere eine Amplituden- und/oder Phasenbeziehung, zwischen dem ersten elektro-magnetischen Störsignal und dem zweiten elektro-magnetischen Störsignal, insbesondere in Form von entsprechenden Korrelationsfaktoren, ermittelt wird.

Beispielsweise ist im Fall des Erdungs-Störsignals davon auszugehen, dass dieses nicht mit den Ultraschallsignalen korreliert, so dass eine Korrelationsanalyse der Empfangssignale ausschließlich eine Korrelation des ersten Störsignals mit dem zweiten Störsignal aufzeigt.

In der Praxis hängt die Korrelation der Störsignale von verschiedenen Faktoren ab, beispielsweise der Wahl des Empfangsmittels (z.B. Induktionsspule oder geerdete Leitung), dem Abstand des Empfangsmittels vom Objekt oder des Abstands des Empfangsmittels zum EMAT-Empfangswandler. Eine Relation zwischen den Störsignalen kann über die Formel $erstes Störsignal = Korrelationsfaktor * zweites Störsignal$ ausgedrückt werden.

Ist eine Relation zwischen den Störsignalen durch Ermittlung entsprechender Korrelationsfaktoren bestimmt, können anhand einer laufenden Messung des zweiten Störsignals Charakteristika des ersten Störsignals besser vorhergesagt bzw. antizipiert werden. Diese Vorhersage kann dann im Zuge der Entstörungsoperation verwendet werden, um eine verbesserte Entstörung des ersten Empfangssignals zu erreichen.

EMAT-Wandler sind in der Regel in der Lage, Ultraschallwellen in einer gewissen Frequenzbandbreite zu erzeugen und zu detektieren. Anteile von Störungen, die innerhalb dieser Frequenzbandbreite liegen, koppeln in das Messsystem ein und können für unterschiedliche Frequenzen der Ultraschallwelle unterschiedliche Charakteristika aufweisen. Vorzugweise wird daher in einer weiteren bevorzugten Ausführungsform der Erfindung eine Korrelationsanalyse in Abhängigkeit der Frequenz der ersten Ultraschallwelle für zumindest zwei verschiedene Frequenzen durchgeführt. Dadurch kann diejenige Frequenz bestimmt und zur Durchführung von Messungen gewählt werden, bei der die Störung weniger in das Messsystem koppelt.

Gemäß einer weiteren bevorzugten Ausgestaltung der Erfindung werden, insbesondere vor und/oder nach der Erzeugung und/oder der Detektion der ersten Ultraschallwelle, das erste elektro-magnetische Störsignal mittels des ersten EMAT-Empfangswandlers und zumindest das zweite elektro-magnetische Störsignal mittels des ersten Empfangsmittels gemeinsam detektiert, wobei eine Korrelation, insbesondere eine Amplituden- und/oder Phasenbeziehung, zwischen dem ersten elektro-magnetischen Störsignal und dem zweiten elektro-magnetischen Störsignal, insbesondere in Form von entsprechenden Korrelationsfaktoren, ermittelt wird. Dadurch kann eine Korrelation zwischen den Störsignalen insbesondere bereits im Vorfeld jeglicher Ultraschallmessungen bestimmt werden, so dass anhand einer laufenden Messung des zweiten Störsignals Charakteristika des ersten Störsignals vorhergesagt bzw. antizipiert und in der Entstörungsoperation verarbeitet werden können.

Vorzugsweise werden das erste Empfangssignal und das zweite Empfangssignal bzw. das erste Störsignal und das zweite Störsignal gemeinsam über einen Zeitraum gemessen, der die Dauer einer Einzelmessung, d.h. das Zeitintervall von dem Senden einer Ultraschallwelle bis zur Detektion des sich daraus ergebenden Signals, überdauert. Insbesondere werden die Signale gemeinsam über einen Zeitraum gemessen, der zumindest das Vierfache, bevorzugt zumindest das Zehnfache der Dauer einer Einzelmessung entspricht.

In einer weiteren vorteilhaften Ausgestaltung der Erfindung wird die Korrelationsanalyse mehrmals hintereinander durchgeführt, wobei auf Basis einer statistischen Analyse von mittels jeweiliger Korrelationsanalysen ermittelten Korrelationsfaktoren gewichtete Korrelationsfaktoren ermittelt werden. Diese können dann in der Entstörungsoperation verarbeitet werden, was zu einer verbesserten Entstörung des ersten Empfangssignals führt. Vorzugsweise werden im laufenden Messbetrieb laufend Korrelationsanalysen durchgeführt und jeweilige Korrelationsfaktoren aktualisiert, so dass das erste Empfangssignal entsprechend der momentanen Charakteristik der Störung optimal entstört werden kann.

In einer weiteren vorteilhaften Ausgestaltung der Erfindung wird mittels eines an oder nahe der Oberfläche des Objekts positionierten zweiten EMAT-Sendewandlers der Messanordnung, der eine zumindest eine Leiterbahn aufweisende zweite Sendewandler-Induktionsspule aufweist, eine zweite Ultraschallwelle in dem Objekt erzeugt, wobei ein an oder nahe der Oberfläche des Objekts positionierter zweiter E-MAT-Empfangswandler der Messanordnung, der eine zumindest eine Leiterbahn aufweisende zweite Empfangswandler-Induktionsspule aufweist, das zweite Empfangssignal detektiert, wobei das zweite Empfangssignal zusätzlich zu dem zweiten elektro-magnetisches Störsignal ein sich zumindest teilweise aus der zweiten Ultraschallwelle, die sich durch zumindest einen Teil des Objekts ausgebreitet hat, ergebendes zweites Ultraschallsignal umfasst, wobei die erste Ultraschallwelle mit einem ersten Modulationsmuster moduliert wird und die zweite Ultraschallwelle mit einem zweiten Modulationsmuster moduliert wird, so dass nach der Detektion eine eindeutige Zuordnung des ersten Ultraschallsignals zur ersten Ultraschallwelle und des zweiten Ultraschallsignals zur zweiten Ultraschallwelle ermöglicht wird, wobei sowohl das erste Empfangssignal als auch das zweite Empfangssignal durch die gemeinsame Verarbeitung in der Entstörungsoperation jeweils zumindest teilweise entstört werden, wobei nach der Entstörungsoperation durch eine Demodulation das erste Ultraschallsignal und das zweite Ultraschallsignal getrennt erhalten werden.

Dadurch ist das vorliegende Verfahren für eine Vielzahl von EMAT-basierten Mess- und Prüfverfahren geeignet, bei denen parallel durchgeführte Ultraschallmessungen notwendig oder wünschenswert sind. Durch Verarbeitung des ersten Empfangssignals und des zweiten Empfangssignals in der Entstörungsoperation werden beide Empfangssignale zumindest teilweise entstört, d.h. sowohl das erste Störsignal als auch das zweite Störsignal werden zumindest teilweise herausgefiltert.

Die Entstörungsoperation kann beispielsweise durch Subtraktion des zweiten Empfangssignals vom ersten Empfangssignal oder umgekehrt erfolgen. Jedoch können auch andere Operationen zur Rauschunterdrückung verwendet werden, sofern sie der erfindungsgemäßen Definition einer Entstörungsoperation entsprechen. Unter der Annahme, dass das erste Störsignal nahezu identisch ist mit dem zweiten Störsignal, löschen sich die Störsignale in der Entstörungsoperation gegenseitig aus. Im Idealfall verbleiben lediglich das erste Ultraschallsignal und das zweite Ultraschallsignal, die anschließend durch die Demodulation voneinander getrennt werden.

Insbesondere werden für das erfindungsgemäße Messverfahren EMAT-Wandler verwendet, die sowohl zum Senden als auch zum Empfangen ausgebildet sind, so dass beispielsweise der erste EMAT-Sendewandler zugleich der zweite EMAT-Empfangswandler ist und der zweite EMAT-Sendewandler zugleich der erste EMAT-Empfangswandler ist. Zur Durchführung des Messverfahrens werden so weniger Komponenten benötigt, wodurch dieses kosteneffizienter implementiert werden kann.

Insbesondere umfasst die Modulation zumindest eine Amplituden- und/oder Phasenmodulation. Vorzugsweise sind die die zur Modulation verwendeten Modulationsmuster orthogonal zueinander, wodurch eine besonders zuverlässige Zuordnung der Ultraschallsignale zu den entsprechenden Ultraschallwellen gewährleistet ist.

Bevorzugt wird zumindest die erste Ultraschallwelle und/oder die zweite Ultraschallwelle als Sequenz von Ultraschallpulsen (Pulsburst) erzeugt und mit einer definierten Sequenz von Amplituden- und/oder Phasenwerten moduliert, d.h. innerhalb eines Pulsbursts findet eine Modulation von Puls zu Puls bzw. von Wellenpaket zu Wellenpaket statt. Dadurch kann eine besonders zuverlässige Zuordnung der Ultraschallsignale zu den entsprechenden Ultraschallwellen erreicht werden.

Gemäß dem bereits vor- sowie dem weiter unten nachbeschrieben wird die eingangs gestellte Aufgabe auch durch eine Messanordnung nach Anspruch 17 gelöst, wobei die Messanordnung zur Durchführung des vor- bzw. nachbeschriebenen Messverfahrens ausgebildet ist. Eine solche Messanordnung umfasst einen an oder nahe einer Oberfläche des Objekts positionierten ersten EMAT-Sendewandler, der eine zumindest eine Leiterbahn aufweisende erste Sendewandler-Induktionsspule aufweist, zur Erzeugung einer ersten Ultraschallwelle in dem Objekt sowie einen an oder nahe der Oberfläche des Objekts positionierten ersten EMAT-Empfangswandler, der eine zumindest eine Leiterbahn aufweisende erste Empfangswandler-Induktionsspule aufweist, zur Detektion eines ersten Empfangssignals, wobei das erste Empfangssignal ein sich zumindest teilweise aus der ersten Ultraschallwelle, die sich durch zumindest einen Teil des Objekts ausgebreitet hat, ergebendes erstes Ultraschallsignal und ein erstes elektro-magnetisches Störsignal umfasst. Die Messanordnung umfasst weiterhin ein zweites Empfangsmittel zur Detektion eines zumindest ein drittes elektro-magnetisches Störsignal umfassenden dritten Empfangssignals, wobei die Messanordnung dazu ausgebildet ist, zumindest das dritte Empfangssignal mit dem ersten Empfangssignal und dem zweiten Empfangssignal in einer zumindest das erste Empfangssignal zumindest teilweise entstörenden Entstörungsoperation zu verarbeiten. Zur Entstörung des ersten Empfangssignals werden somit zumindest zwei weitere, sich voneinander unterscheidende Empfangssignale detektiert und verarbeitet, was zu einem verbesserten Signal-Rausch-Verhältnis führt, wie dies bereits zum dazugehörigen Messverfahren entsprechend erörtert wurde. Die Messanordnung umfasst hierzu ein Entstörungsmittel. Ebenfalls ist die Messanordnung dazu ausgebildet, das zumindest ein zweites elektro-magnetisches Störsignal umfassende zweite Empfangssignal zu detektieren, während das erste Empfangssignal vom EMAT-Wandler detektiert wird.

Gemäß einer bevorzugten Ausgestaltung der Erfindung umfasst das erste Empfangsmittel eine Empfangsmittel-Induktionsspule, wodurch sich die detektierten Störsignale weitgehend ähneln. Besonders bevorzugt ist die Empfangsmittel-Induktionsspule zumindest im Wesentlichen baugleich zur ersten Empfangswandler-Induktionsspule ausgebildet, wodurch die Störsignale sich weitestgehend ähneln, insbesondere nahezu identisch sind. Durch diese Maßnahmen kann das Signal-Rausch-Verhältnis verbessert werden, wie dies bereits zum dazugehörigen Messverfahren entsprechend dargelegt wurde.

Vorzugsweise wird die Empfangsmittel-Induktionsspule von der ersten Sendewandler-Induktionsspule oder einer weiteren, von der Empfangswandler-Induktionsspule verschiedenen Induktionsspule der Messanordnung ausgebildet. So wird zur kostengünstigen Implementierung der Entstörung auf bereits vorhandene Komponenten der Messanordnung zurückgegriffen.

In einer weiteren bevorzugten Ausgestaltung der Erfindung umfasst die Messanordnung eine mit dem Objekt oder einem geerdeten Gehäuseteil eines die Messanordnung schützenden Gehäuses elektrisch leitfähig verbundene oder in sonstiger Weise geerdete Leitung zur Detektion des zweiten Empfangssignals. Auf diese Weise kann insbesondere ein Störsignal, das von einer Potentialdifferenz zwischen dem EMAT-System und dem in der Regel geerdeten Objekt herrührt, separat aufgezeichnet und zur Verbesserung des Signal-Rausch-Verhältnisses in der Entstörungsoperation verarbeitet werden, wie dies bereits zum dazugehörigen Messverfahren entsprechend dargelegt wurde. Bevorzugt ist die Leitung dabei mit einer Messleitung der Messanordnung unter Beibehaltung einer galvanischen Trennung, insbesondere kapazitiv, signalübertragend verbunden.

Gemäß einer weiteren bevorzugten Ausgestaltung der Erfindung umfasst das Entstörungsmittel ein analoges und/oder digitales elektrisches und/oder elektronisches Bauelement, insbesondere eine Gleichtaktdrossel, oder eine analoge und/oder digitale, elektrische und/oder elektronische Schaltung. Ein derart ausgebildetes Entstörungsmittel kann in einfacher Weise und kostengünstig implementiert werden. Alternativ kann als Entstörungsmittel auch eine Datenverarbeitungsanlage verwendet werden, wobei die Entstörungsoperation durch eine auf der Datenverarbeitungsanlage laufende Software implementiert werden kann. Vorzugsweise dient eine Steuer- und Auswerteeinheit der Messanordnung als Datenverarbeitungsanlage, auf der die Entstörungsoperation implementiert ist.

Vorzugsweise ist zwischen dem Entstörungsmittel einerseits und dem ersten EMAT-Empfangswandler und dem ersten Empfangsmittel andererseits eine erste Verstärkerstufe der Messanordnung geschaltet ist. Dadurch ist das Verfahren auch in explosionsgefährdeten Bereichen anwendbar, wie dies bereits zum dazugehörigen Messverfahren entsprechend dargelegt wurde.

Insbesondere ist zwischen dem Entstörungsmittel einerseits und zumindest dem ersten EMAT-Empfangswandler und dem ersten Empfangsmittel andererseits eine Explosionsschutz-Barriere (EX-Barriere) eingerichtet. Dadurch ist das Verfahren auch in explosionsgefährdeten Bereichen anwendbar, wie dies bereits zum dazugehörigen Messverfahren entsprechend erläutert wurde.

Vorzugsweise umfasst die Messanordnung eine Auswerteeinheit zur Durchführung einer Korrelationsanalyse nach einem der Ansprüche 11 bis 14. Auf diese Weise kann eine Relation zwischen den Störsignalen durch Ermittlung entsprechender Korrelationsfaktoren bestimmt und so anhand einer laufenden Messung des zweiten Störsignals Charakteristika des ersten Störsignals vorhergesagt bzw. antizipiert werden. Diese Vorhersage kann dann im Zuge der Entstörungsoperation verwendet werden, um eine verbesserte Entstörung des ersten Empfangssignals zu erreichen, wie dies bereits zum dazugehörigen Messverfahren entsprechend dargelegt wurde.

In einer weiteren bevorzugten Ausgestaltung der Erfindung umfasst die Messanordnung einen an oder nahe der Oberfläche positionierten zweiten EMAT-Sendewandler, der eine zumindest eine Leiterbahn aufweisende zweite Sendewandler-Induktionsspule aufweist, zur Erzeugung einer zweiten Ultraschallwelle in dem Objekt, wobei die Messanordnung ferner einen an oder nahe der Oberfläche des Objekts positionierten zweiten EMAT-Empfangswandler umfasst, der eine zumindest eine Leiterbahn aufweisende zweite Empfangswandler-Induktionsspule aufweist, zur Detektion des zweiten Empfangssignals, wobei das zweite Empfangssignal zusätzlich zu dem zweiten elektro-magnetisches Störsignal ein sich zumindest teilweise aus der zweiten Ultraschallwelle, die sich durch zumindest einen Teil des Objekts ausgebreitet hat, ergebendes zweites Ultraschallsignal umfasst, wobei die Messanordnung ferner zumindest ein Modulationsmittel umfasst, das die erste Ultraschallwelle mit einem ersten Modulationsmuster und die zweite Ultraschallwelle mit einem zweiten Modulationsmuster moduliert, so dass nach der Detektion eine eindeutige Zuordnung des ersten Ultraschallsignals zur ersten Ultraschallwelle und des zweiten Ultraschallsignals zur zweiten Ultraschallwelle ermöglicht wird, wobei die Messanordnung dazu ausgebildet ist, dass sowohl das erste Empfangssignal als auch das zweite Empfangssignal durch die gemeinsame Verarbeitung in der Entstörungsoperation jeweils zumindest teilweise entstört werden, wobei die Messanordnung ferner zumindest ein Demodulationsmittel umfasst und die Messanordnung dazu ausgebildet ist, dass nach der Entstörungsoperation das erste Ultraschallsignal und das zweite Ultraschallsignal getrennt werden.

Dadurch ist das vorliegende Verfahren zur Verbesserung des Signal-Rausch-Verhältnisses für eine Vielzahl von EMAT-basierten Mess- und Prüfverfahren geeignet, bei denen parallel durchgeführte Ultraschallmessungen notwendig oder wünschenswert sind, wie dies bereits zum dazugehörigen Messverfahren entsprechend dargelegt wurde.

Insbesondere sind die EMAT-Wandler sowohl zum Senden als auch zum Empfangen ausgebildet, so dass beispielsweise der erste EMAT-Sendewandler zugleich der zweite EMAT-Empfangswandler ist und der zweite EMAT-Sendewandler zugleich der erste EMAT-Empfangswandler ist, was eine besonders kompakte Umsetzung der Entstörung ermöglicht.

Es wird ausdrücklich darauf hingewiesen, dass die vorstehend erläuterten Ausgestaltungen der Erfindung jeweils für sich oder in einer beliebigen technisch sinnvollen Kombination auch untereinander kombinierbar sind, wobei der Schutzbereich nur durch den Umfang der Ansprüche abgedeckt ist**.**

Abwandlungen und Ausgestaltungen der Erfindung sowie weitere Vorteile und Einzelheiten der Erfindung lassen sich der nachfolgenden gegenständlichen Beschreibung und den Zeichnungen entnehmen.

In den schematischen Figuren zeigen:
- Fig. 1: eine nicht-erfindungsgemäße Ausführungsform,
- Fig. 2: eine weitere nicht-erfindungsgemäße Ausführungsform,
- Fig. 3: eine weitere nicht-erfindungsgemäße Ausführungsform,
- Fig. 4: eine weitere nicht-erfindungsgemäße Ausführungsform,
- Fig. 5: eine weitere nicht-erfindungsgemäße Ausführungsform,
- Fig. 6: eine weitere nicht-erfindungsgemäße Ausführungsform,
- Fig. 7: eine weitere nicht-erfindungsgemäße Ausführungsform,
- Fig. 8: eine Ausführungsform der Erfindung.

Gleich oder ähnlich wirkende Teile sind - sofern dienlich - mit identischen Bezugsziffern versehen.

Einzelne technische Merkmale der nachbeschriebenen Ausführungsbeispiele können auch in Kombination mit vorbeschriebenen Ausführungsbeispielen sowie den Merkmalen der unabhängigen Ansprüche und etwaiger weiterer Ansprüche zu erfindungsgemäßen Gegenständen kombiniert werden.

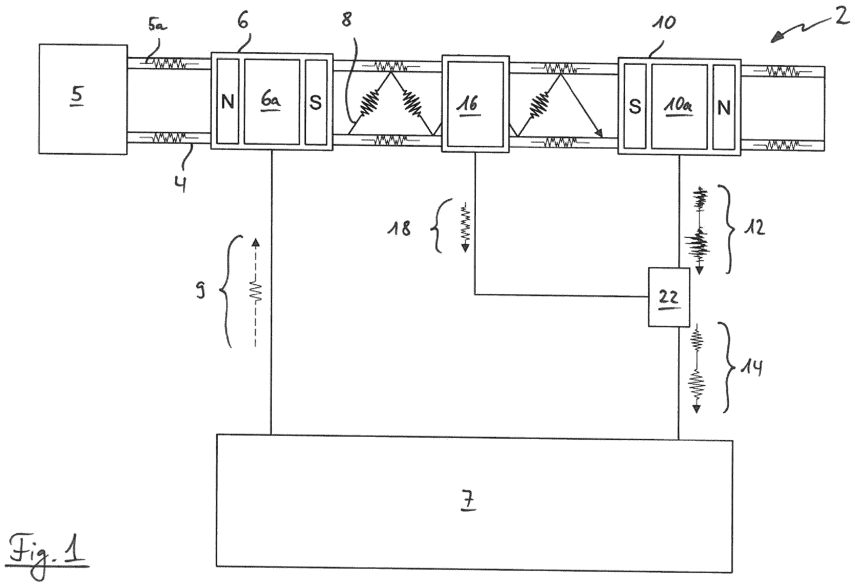

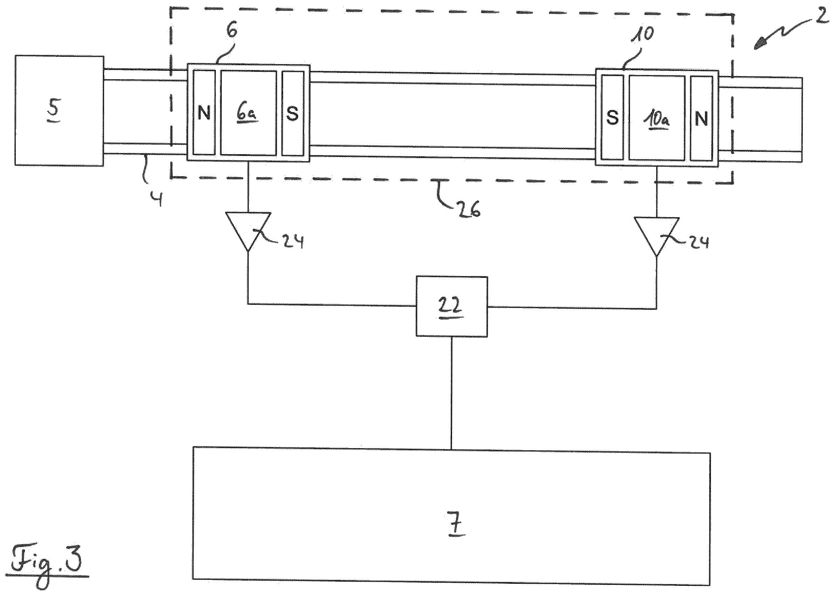

In den Figuren 1 bis 8 werden verschiedene Ausführungsbeispiele einer Messanordnung 2 gezeigt, die eine Ultraschall-Durchflussmessung an einem als Pipeline ausgebildeten leitfähigen Objekt 4 durchführt. Eine mit dem Objekt 4 wechselwirkende Störquelle 5 - schematisch veranschaulicht durch direkten Kontakt der Störquelle 5 mit einer Stirnseite des Objekts 4 - erzeugt Störungen, die sich durch die Objektwand ausbreiten und in die Induktionsspulen 6a, 10a ,16 des Messsystems einkoppeln. Mittels eines an oder nahe einer Oberfläche des Objekts 4 positionierten ersten EMAT-Sendewandlers 6 der Messanordnung 2, der eine zumindest eine Leiterbahn aufweisende erste Sendewandler-Induktionsspule 6a aufweist, wird eine erste Ultraschallwelle 8 in dem Objekt 4 erzeugt. Dazu wird der erste EMAT-Sendewandler 6 von einer Steuer- und Auswerteeinheit 7 der Messanordnung 2 durch einen Wechselstrompuls 9 angeregt (Ultraschallwellen, -signale oder -pulse oder Strompulse in den Figuren 3, 5, 7 und 8 nicht gezeigt), der mit dem Magnetfeld des Wandlers - veranschaulicht durch die Magnetpole N, S - wechselwirkt. Die in den Figuren dargestellte Polarität des Magnetfeldes dient dabei lediglich Veranschaulichungszwecken. Es ist ersichtlich, dass die Polarität auch anders gestaltet sein kann oder dass das Magnetfeld von einem Elektromagneten mit variablem Magnetfeld erzeugt werden kann. Mittels eines an oder nahe der Oberfläche des Objekts 4 positionierten ersten EMAT-Empfangswandlers 10 der Messanordnung 2, der eine zumindest eine Leiterbahn aufweisende erste Empfangswandler-Induktionsspule 10a aufweist, wird ein erstes Empfangssignal 12 detektiert, wobei das erste Empfangssignal 12 ein sich zumindest teilweise aus der ersten Ultraschallwelle 8, die sich durch zumindest einen Teil des Objekts 4 ausgebreitet hat, ergebendes erstes Ultraschallsignal 14 und ein erstes elektro-magnetisches Störsignal umfasst. Dabei wird, insbesondere während das erste Empfangssignal 12 vom ersten EMAT-Empfangswandler 6 detektiert wird, mittels eines ersten Empfangsmittels der Messanordnung 2 ein zweites Empfangssignal 18 detektiert, das zumindest ein zweites elektro-magnetisches Störsignal umfasst. Zumindest das erste Empfangssignal 12 und das zweite Empfangssignal 18 werden mittels eines Entstörungsmittels 22 der Messanordnung 2 gemeinsam in einer Entstörungsoperation verarbeitet, wobei zumindest das erste Empfangssignal 12 zumindest teilweise entstört wird.

In der in Fig. 1 gezeigten Ausführungsform wird das zweite Empfangssignal 18 von einer an oder nahe der Oberfläche des Objekts 4 positionierten und zumindest eine Leiterbahn aufweisenden Empfangsmittel-Induktionsspule 16 des ersten Empfangsmittels detektiert. Hierbei ist das detektierte zweite Störsignal ein Spulen-Störsignal. Bevorzugt ist die Empfangsmittel-Induktionsspule 16 im Wesentlichen baugleich zur ersten Empfangswandler-Induktionsspule 10a, wodurch das erste Störsignal und das zweite Störsignal im Wesentlichen die gleichen Charakteristika aufweisen, was zu einer besonders effektiven Entstörung im Zuge der Entstörungsoperation führt. Bei dieser Ausführungsform liegt an der Empfangsmittel-Induktionsspule 16 kein Magnetfeld an, so dass das Empfangsmittel im Gegensatz zu den EMAT-Wandlern 6, 10 kein Signal aufzeichnet, das sich aus der ersten Ultraschallwelle 8 ergibt.

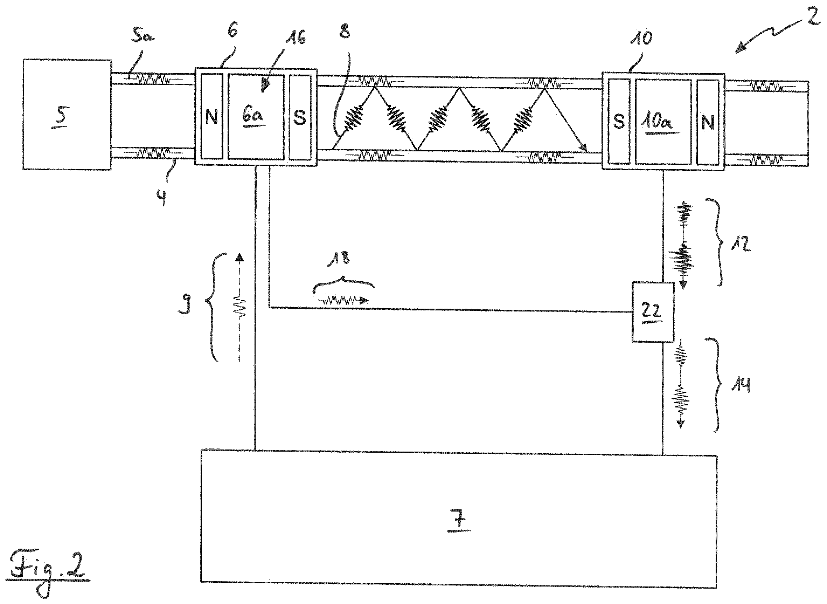

Gemäß der in Fig. 2 gezeigten Ausführungsform wird zur Detektion des zweiten Empfangssignals 18 die erste Sendewandler-Induktionsspule 6a als Empfangsmittel-Induktionsspule 16 verwendet. Beispielsweise im Fall, dass die Messanordnung 2 mehr als zwei EMAT-Wandler aufweist, kann alternativ eine weitere, von der Empfangswandler-Induktionsspule 10a verschiedene Induktionsspule der Messanordnung 2 als Empfangsmittel-Induktionsspule 16 dienen.

Bei der in Fig. 3 gezeigten Ausführungsform wird ähnlich wie in Fig. 2 der erste E-MAT-Sendewandler 6 als Empfangsmittel verwendet. Zudem passieren das erste Empfangssignal 12 und das zweite Empfangssignal 18 eine erste Verstärkerstufe 24, bevor sie anhand des Entstörungsmittels 22 in der Entstörungsoperation verarbeitet werden. Dadurch wird insbesondere bei der Verwendung eines Entstörungsmittels 22 mit induktiven Bauelementen, wie z.B. einer Gleichtaktdrossel, die Induktivität in einem Sensorbereich 26 der Messanordnung 2, der zumindest den ersten E-MAT-Sendewandler 6 und den ersten EMAT-Empfangswandler 10 umfasst, nicht erhöht, wodurch das Verfahren auch in explosionsgefährdeten Bereichen anwendbar ist.

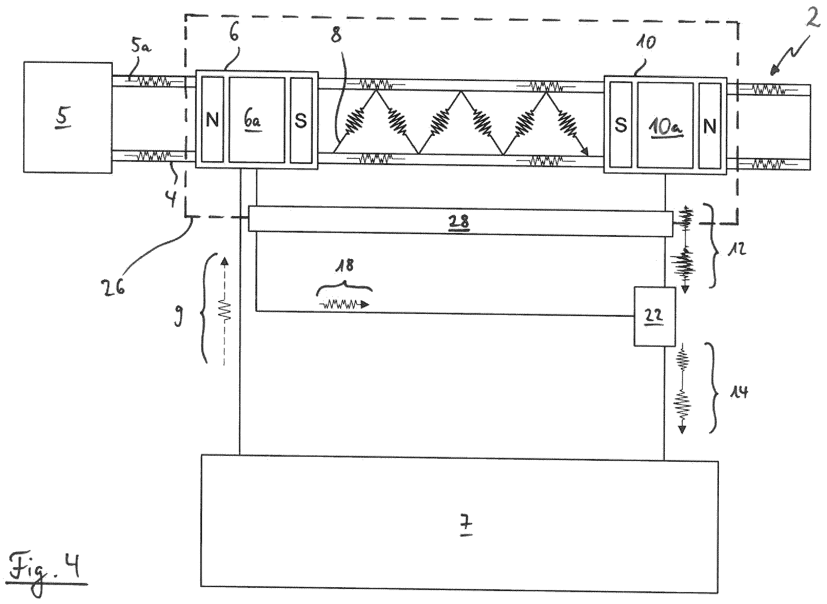

Fig. 4 zeigt eine weitere Ausführungsform, bei der der erste EMAT-Sendewandler 6 als Empfangsmittel verwendet wird. Aus Gründen der Übersichtlichkeit sind hierbei keine Ultraschallwellen, -signale oder -pulse dargestellt. Das erste Empfangssignal 12 und das zweite Empfangssignal 18 passieren eine den Sensorbereich 26 der Messanordnung 2 abschirmende Explosionsschutz-Barriere 28 (EX-Barriere) der Messanordnung 2, bevor sie in der Entstörungsoperation verarbeitet werden.

Dadurch kann das Verfahren auch in explosionsgefährdeten Bereichen durchgeführt werden. Insbesondere werden zur Umsetzung der Explosionsschutz-Barriere 28 spannungsbegrenzende Dioden verwendet.

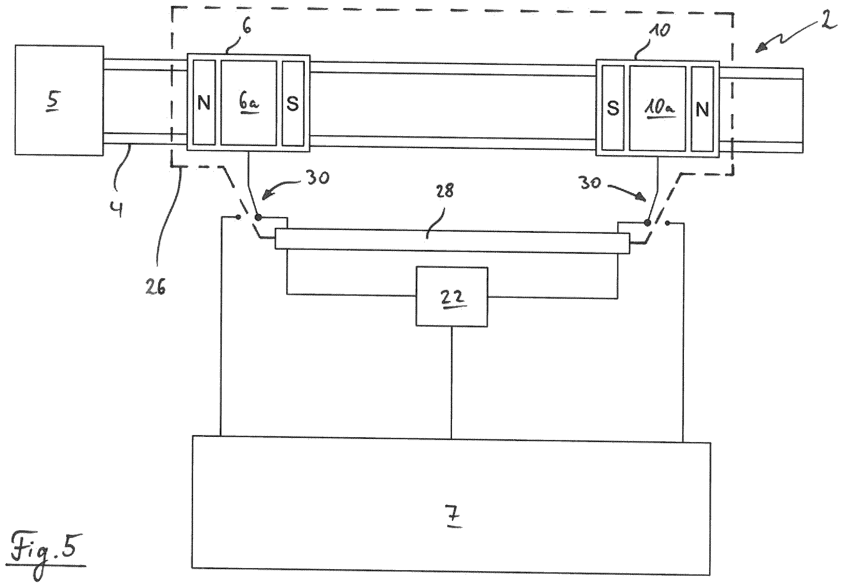

Fig. 5 zeigt eine weitere Ausführungsform mit Explosionsschutz-Barriere 28, bei der die EMAT-Wandler 6, 10 sowohl zum Senden als auch zum Empfangen ausgebildet sind. Dabei kann mittels Schaltern 30 zwischen einem Sende- und Empfangsmodus der EMAT-Wandler 6, 10 geschaltet werden. Die Explosionsschutz-Barriere 28 ist so zu platzieren, dass der Sensorbereich 26 zumindest von den zum Entstörungsmittel 22 führenden Empfangsleistungen abgeschirmt wird.

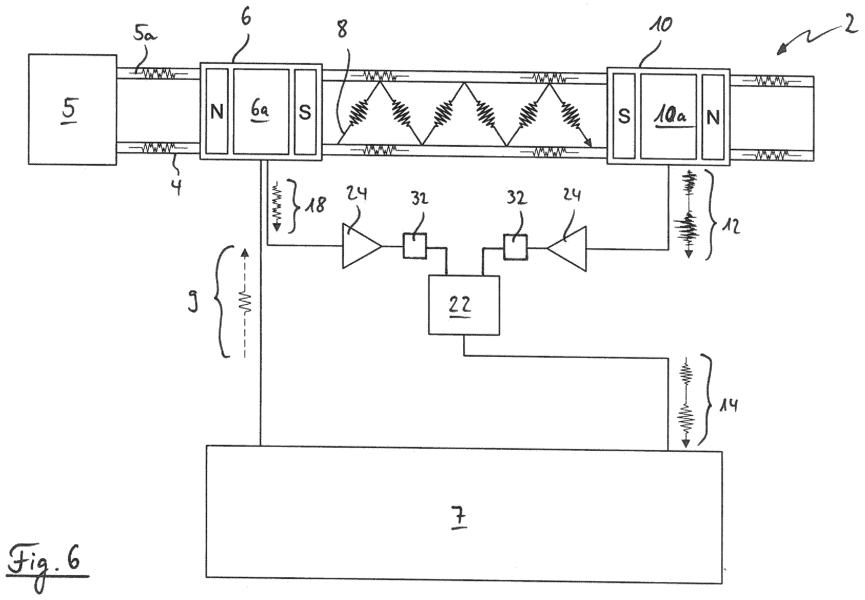

Fig. 6 zeigt eine zu Fig. 3 ähnliche Ausführungsform. Dabei werden das erste Empfangssignal 12 und das zweite Empfangssignal 18 jedoch mittels elektronischer Subtraktion als Entstörungsoperation gemeinsam verarbeitet. Die Signale werden dabei einer digitalen Schaltung als Entstörungsmittel 22 zugeführt, wobei sie nach der Verstärkung zunächst jeweils einen Analog-Digital-Wandler 32 passieren.

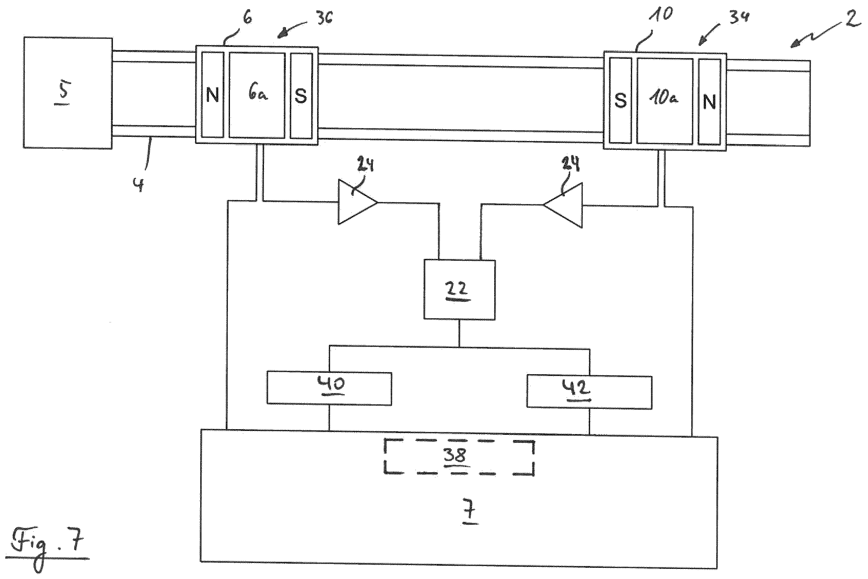

Fig. 7 zeigt eine weitere Ausführungsform der Messanordnung 2, bei der die EMAT-Wandler 6, 10 zum insbesondere gleichzeitigen Senden und Empfangen ausgebildet sind. Aus Gründen der Übersichtlichkeit sind hierbei keine Ultraschallwellen, -signale oder -pulse dargestellt. Der erste EMAT-Sendewandler 6 dient zugleich als ein zweiter EMAT-Empfangswandler 36 und der erste EMAT-Empfangswandler 10 dient ist zugleich als ein zweiter EMAT-Sendewandler 34. Der erste EMAT-Sendewandler 6 erzeugt die mit einem ersten Modulationsmuster modulierte erste Ultraschallwelle 8, während der erste EMAT-Empfangswandler 10 ein erstes Empfangssignal 12 aufzeichnet, das sowohl das sich zumindest teilweise aus der ersten Ultraschallwelle 8 ergebende erste Ultraschallsignal 14 als auch das erste Störsignal umfasst. Der zweite EMAT-Sendewandler 34 erzeugt ferner eine mit einem zweiten Modulationsmuster modulierte zweite Ultraschallwelle, wobei der zweite EMAT-Empfangswandler 36 das zweite Empfangssignal 18 aufzeichnet, das neben dem zweiten Störsignal in Form eines Spulen-Störsignals auch ein sich zumindest teilweise aus der zweiten Ultraschallwelle ergebendes zweites Ultraschallsignal umfasst.

Zur Modulation weist die Messanordnung 2 ein Modulationsmittel 38 auf, das in dieser Ausführungsform Teil der Steuer- und Auswerteeinheit 7 ist. Durch die Modulation kann auch nach der Detektion das erste Ultraschallsignal 14 zur ersten Ultraschallwelle 8 und das zweite Ultraschallsignal zur zweiten Ultraschallwelle zugeordnet werden. Daher können sowohl das erste Empfangssignal 12 als auch das zweite Empfangssignal gemeinsam in der auf dem Entstörungsmittel 22 ablaufenden Entstörungsoperation verarbeitet werden, wobei beide Empfangssignale zumindest teilweise entstört werden. Anschließend wird das entstörte Gesamtsignal einem ersten Demodulationsmittel 40 und einem zweiten Demodulationsmittel 42 zugeführt, wobei das erste Demodulationsmittel 40 durch Demodulation entsprechend dem ersten Modulationsmuster das erste Ultraschallsignal 14 liefert und das zweite Demodulationsmittel 42 durch Demodulation entsprechend dem zweiten Modulationsmuster das zweite Ultraschallsignal liefert. Schließlich werden das entstörte erste Ultraschallsignal 14 und das entstörte zweite Ultraschallsignal getrennt zur weiteren Auswertung an die Steuer- und Auswerteeinheit 7 weitergeleitet. Die Demodulationsmittel 40, 42 können auch als einzelne Komponente ausgebildet und/oder in die Steuer- und Auswerteeinheit 7 integriert sein.

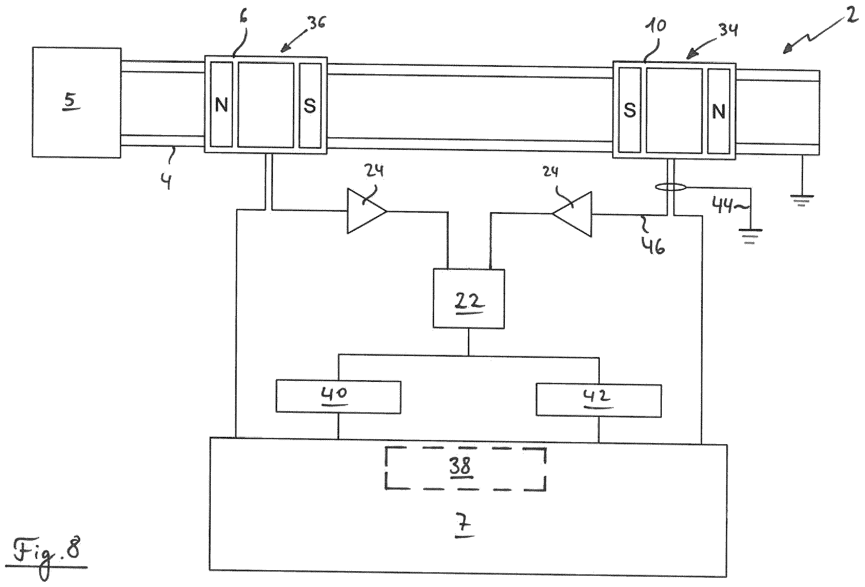

Fig. 8 zeigt eine zu Fig. 7 analoge, erfindungsgemäße Ausführungsform, wobei die Messanordnung 2 zusätzlich ein zweites Empfangsmittel in Form einer geerdeten Leitung 44 aufweist, die zur Detektion eines dritten Empfangssignals dient. Hierbei umfasst das dritte Empfangssignal ein drittes elektro-magnetisches Störsignal, genauer ein Erdungs-Störsignal. Dieses Erdungs-Störsignal hat seinen Ursprung darin, dass das Objekt 4 geerdet ist und eine Potentialdifferenz zu dem davon galvanisch getrennten Messsystem als Störsignal in das Messsystem einkoppelt. Zur Messung dieses dritten Empfangssignals ist das zweite Empfangsmittel kapazitiv signalübertragend mit einer Messleitung 46 der Messanordnung 2 verbunden, wodurch die galvanische Trennung beibehalten wird.

Es werden in dieser Ausführungsform daher zwei Arten von Störsignalen detektiert: Der zweite EMAT-Empfangswandler 36 dient als erstes Empfangsmittel und zeichnet als Teil des zweiten Empfangssignals 18 ein Spulen-Störsignal auf. Die geerdete Leitung 18 dient als zweites Empfangsmittel und zeichnet als Teil des dritten Empfangssignals ein Erdungs-Störsignal auf. Das erste Empfangssignal 12, das zweite Empfangssignal 18 und das dritte Empfangssignal werden gemeinsam in der Entstörungsoperation verarbeitet, wobei das erste Empfangssignal 12 und das zweite Empfangssignal 18 zumindest teilweise entstört werden. Auf diese Weise werden sowohl Störungen 5a, die von mit dem Objekt 4 wechselwirkenden Störquellen 5 stammen, als auch Störungen, die sich aus der Potentialdifferenz des Messsystems zu geerdeten Strukturen ergeben, unterdrückt. So wird das Signal-Rausch-Verhältnis bei der hier zugrundeliegenden Durchflussmessung erheblich verbessert.

Zur verbesserten Rauschunterdrückung, insbesondere der sich aus der Potentialdifferenz zwischen dem Messsystem und dem geerdeten Objekt 4 ergebenden Störungen, wird vorzugsweise im Vorfeld und/oder während der Ultraschallmessung eine Korrelationsanalyse zur Bestimmung einer Korrelation, insbesondere einer Amplituden- und/oder Phasenbeziehung, zwischen dem ersten Empfangssignal 12 und dem dritten Empfangssignal bzw. zwischen dem ersten Störsignal und dem dritten Störsignal durchgeführt. Ist eine Relation zwischen den Störsignalen durch Ermittlung entsprechender Korrelationsfaktoren bestimmt, können anhand einer laufenden Messung des zweiten Störsignals Charakteristika des ersten Störsignals vorhergesagt bzw. antizipiert werden. Diese Vorhersage kann dann im Zuge der Entstörungsoperation verwendet werden, um eine verbesserte Entstörung des ersten Empfangssignals 12 und ggf. des zweiten Empfangssignals zu erreichen.

## Patentansprüche

1. Messverfahren an einem elektrisch leitfähigen Objekt (4), wobei mittels eines an oder nahe einer Oberfläche des Objekts (4) positionierten ersten EMAT-Sendewandlers (6) einer Messanordnung (2), der eine zumindest eine Leiterbahn aufweisende erste Sendewandler-Induktionsspule (6a) aufweist, eine erste Ultraschallwelle (8) in dem Objekt (4) erzeugt wird und ein an oder nahe der Oberfläche des Objekts (4) positionierter erster EMAT-Empfangswandler (10) der Messanordnung (2), der eine zumindest eine Leiterbahn aufweisende erste Empfangswandler-Induktionsspule (10a) aufweist, ein erstes Empfangssignal (12) detektiert, wobei das erste Empfangssignal (12) ein sich zumindest teilweise aus der ersten Ultraschallwelle (8), die sich durch zumindest einen Teil des Objekts (4) ausgebreitet hat, ergebendes erstes Ultraschallsignal (14) und ein erstes elektro-magnetisches Störsignal umfasst, wobei ein zweites Empfangssignal (18) mittels eines ersten Empfangsmittels der Messanordnung (2) detektiert wird, während das erste Empfangssignal (12) vom ersten EMAT-Empfangswandler (10) detektiert wird, und das zweite Empfangssignal (18) zumindest ein zweites elektro-magnetisches Störsignal umfasst, **dadurch gekennzeichnet, dass** mittels eines vom ersten Empfangsmittel verschiedenen zweiten Empfangsmittels der Messanordnung (2) zumindest ein drittes Empfangssignals detektiert wird, während das erste Empfangssignal (12) vom ersten EMAT-Empfangswandler (10) detektiert wird, wobei das dritte Empfangssignal vom zweiten Empfangssignal (18) verschieden ist und ein drittes elektro-magnetisches Störsignal umfasst, wobei das dritte elektro-magnetische Störsignal ein Spulen-Störsignal oder ein Erdungs-Störsignal ist, und zumindest das dritte Empfangssignal gemeinsam mit dem ersten Empfangssignal (12) und dem zweiten Empfangssignal (18) in einer Entstörungsoperation mittels eines Entstörungsmittels (22) der Messanordnung (2) verarbeitet wird, wobei zumindest das erste Empfangssignal (12) zumindest teilweise entstört wird.

2. Messverfahren nach Anspruch 1, **dadurch gekennzeichnet, dass** das zweite Empfangssignal (18) von einer an oder nahe der Oberfläche des Objekts (4) positionierten und zumindest eine Leiterbahn aufweisenden Empfangsmittel-Induktionsspule (16) des ersten Empfangsmittels detektiert wird, wobei als zweites Störsignal ein Spulen-Störsignal detektiert wird.

3. Messverfahren nach Anspruch 2, **dadurch gekennzeichnet, dass** die zur Detektion des zweiten Empfangssignals (18) verwendete Empfangsmittel-Induktionsspule (16) zumindest im Wesentlichen baugleich zur ersten Empfangswandler-Induktionsspule (10a) ist.

4. Messverfahren nach einem der Ansprüche 2 oder 3, **dadurch gekennzeichnet, dass** als Empfangsmittel-Induktionsspule (16) zur Detektion des zweiten Empfangssignals (18) die erste Sendewandler-Induktionsspule (6a) oder eine weitere, von der Empfangswandler-Induktionsspule (10a) verschiedene Induktionsspule der Messanordnung (2) verwendet wird.

5. Messverfahren nach Anspruch 1, **dadurch gekennzeichnet, dass** das zweite Empfangssignal (18) mittels einer mit dem Objekt (4) oder einem geerdeten Gehäuseteil eines die Messanordnung (2) schützenden Gehäuses elektrisch leitfähig verbundenen oder in sonstiger Weise geerdeten Leitung (44) der Messanordnung (2) als erstes Empfangsmittel detektiert wird, wobei als zweites Störsignal ein Erdungs-Störsignal detektiert wird.

6. Messverfahren nach Anspruch 5, **dadurch gekennzeichnet, dass** das über die Leitung (44) abgegriffene zweite Empfangssignal (18) in eine Messleitung (46) der Messanordnung (2) unter Beibehaltung einer galvanischen Trennung, insbesondere kapazitiv, eingekoppelt wird.

7. Messverfahren nach einem der vorstehen den Ansprüche, **dadurch gekennzeichnet, dass** zumindest das erste Empfangssignal (12) und das zweite Empfangssignal (18) einem analogen und/oder digitalen, elektrischen und/oder elektronischen Bauelement oder einer analogen und/oder digitalen, elektrischen und/oder elektronischen Schaltung als Entstörungsmittel (22) zugeführt werden, insbesondere wobei die Entstörungsoperation zumindest eine Subtraktion der Empfangssignale (12, 18) umfasst.

8. Messverfahren nach einem der vorstehenden Ansprüche, **dadurch gekennzeichnet, dass** das erste Empfangssignal (12) und das zweite Empfangssignal (18) einer Gleichtaktdrossel als Entstörungsmittel (22) zugeführt und einer induktiven Subtraktion als Entstörungsoperation unterzogen werden.

9. Messverfahren nach einem der vorstehenden Ansprüche, **dadurch gekennzeichnet, dass** das erste Empfangssignal (12) und das zweite Empfangssignal (18) eine erste Verstärkerstufe (24) passieren, bevor sie in der Entstörungsoperation verarbeitet werden.

10. Messverfahren nach einem der vorstehenden Ansprüche, **dadurch gekennzeichnet, dass** das erste Empfangssignal (12) und das zweite Empfangssignal (18) eine einen Sensorbereich (26) der Messanordnung (2), der zumindest den ersten E-MAT-Sendewandler (6) und den ersten EMAT-Empfangswandler (10) umfasst, abschirmende Explosionsschutz-Barriere (28) (EX-Barriere) der Messanordnung (2) passieren, bevor sie in der Entstörungsoperation verarbeitet werden.

11. Messverfahren nach einem der vorstehenden Ansprüche, **dadurch gekennzeichnet, dass** das erste Empfangssignal (12) und das zweite Empfangssignal (18), insbesondere vor der Entstörungsoperation, einer Korrelationsanalyse unterzogen werden, wobei eine Korrelation, insbesondere eine Amplituden- und/oder Phasenbeziehung, zwischen dem ersten elektro-magnetischen Störsignal und dem zweiten elektro-magnetischen Störsignal, insbesondere in Form von entsprechenden Korrelationsfaktoren, ermittelt wird.

12. Messverfahren nach Anspruch 11, **dadurch gekennzeichnet, dass** eine Korrelationsanalyse in Abhängigkeit der Frequenz der ersten Ultraschallwelle (8) für zumindest zwei verschiedene Frequenzen durchgeführt wird.

13. Messverfahren nach einem der vorstehenden Ansprüche, **dadurch gekennzeichnet, dass**, insbesondere vor und/oder nach der Erzeugung und/oder der Detektion der ersten Ultraschallwelle (8), das erste elektro-magnetische Störsignal mittels des ersten EMAT-Empfangswandlers (10) und zumindest das zweite elektro-magnetische Störsignal mittels des ersten Empfangsmittels gemeinsam detektiert werden, wobei eine Korrelation, insbesondere eine Amplituden- und/oder Phasenbeziehung, zwischen dem ersten elektro-magnetischen Störsignal und dem zweiten elektro-magnetischen Störsignal, insbesondere in Form von entsprechenden Korrelationsfaktoren, ermittelt wird.

14. Messverfahren nach einem der vorstehenden Ansprüche, **dadurch gekennzeichnet, dass** die Korrelationsanalyse nach einem der Ansprüche 11 bis 13 mehrmals hintereinander durchgeführt wird und auf Basis einer statistischen Analyse von mittels jeweiliger Korrelationsanalysen ermittelten Korrelationsfaktoren gewichtete Korrelationsfaktoren ermittelt werden.

15. Messverfahren nach einem der vorstehenden Ansprüche, **dadurch gekennzeichnet, dass** mittels eines an oder nahe der Oberfläche des Objekts (4) positionierten zweiten EMAT-Sendewandlers (34) der Messanordnung (2), der eine zumindest eine Leiterbahn aufweisende zweite Sendewandler-Induktionsspule aufweist, eine zweite Ultraschallwelle in dem Objekt (4) erzeugt wird und ein an oder nahe der Oberfläche des Objekts positionierter zweiter EMAT-Empfangswandler (36) der Messanordnung (2), der eine zumindest eine Leiterbahn aufweisende zweite Empfangswandler-Induktionsspule aufweist, das zweite Empfangssignal (18) detektiert, wobei das zweite Empfangssignal (18) zusätzlich zu dem zweiten elektro-magnetisches Störsignal ein sich zumindest teilweise aus der zweiten Ultraschallwelle, die sich durch zumindest einen Teil des Objekts (4) ausgebreitet hat, ergebendes zweites Ultraschallsignal umfasst, wobei die erste Ultraschallwelle (8) mit einem ersten Modulationsmuster moduliert wird und die zweite Ultraschallwelle mit einem zweiten Modulationsmuster moduliert wird, so dass nach der Detektion eine eindeutige Zuordnung des ersten Ultraschallsignals (14) zur ersten Ultraschallwelle (8) und des zweiten Ultraschallsignals zur zweiten Ultraschallwelle ermöglicht wird, wobei sowohl das erste Empfangssignal (12) als auch das zweite Empfangssignal (18) durch die gemeinsame Verarbeitung in der Entstörungsoperation jeweils zumindest teilweise entstört werden, wobei nach der Entstörungsoperation durch eine Demodulation das erste Ultraschallsignal (14) und das zweite Ultraschallsignal getrennt erhalten werden.

16. Messverfahren nach Anspruch 15, **dadurch gekennzeichnet, dass** die zur Modulation verwendeten Modulationsmuster orthogonal zueinander sind.

17. Messanordnung (2) zur Durchführung eines Messverfahrens an einem elektrisch leitfähigen Objekt (4) nach einem der Ansprüche 1 bis 16, mit einem an oder nahe einer Oberfläche des Objekts (4) positionierten ersten EMAT-Sendewandler (6), der eine zumindest eine Leiterbahn aufweisende erste Sendewandler-Induktionsspule (6a) aufweist, zur Erzeugung einer ersten Ultraschallwelle (8) in dem Objekt (4) und mit einem an oder nahe der Oberfläche des Objekts (4) positionierten ersten EMAT-Empfangswandler (10), der eine zumindest eine Leiterbahn aufweisende erste Empfangswandler-Induktionsspule (10a) aufweist, zur Detektion eines ersten Empfangssignals (12), wobei das erste Empfangssignal (12) ein sich zumindest teilweise aus der ersten Ultraschallwelle (8), die sich durch zumindest einen Teil des Objekts (4) ausgebreitet hat, ergebendes erstes Ultraschallsignal (14) und ein erstes elektro-magnetisches Störsignal umfasst, wobei die Messanordnung (2) dazu ausgebildet ist, ein zweites Empfangssignal (18) zu detektieren, und ein Entstörungsmittel (22) umfasst, wobei die Messanordnung (2) dazu ausgebildet ist, das erste Empfangssignal (12) und das zweite Empfangssignal (18) mittels des Entstörungsmittels (22) in einer zumindest das erste Empfangssignal (12) zumindest teilweise entstörenden Entstörungsoperation zu verarbeiten, wobei die Messanordnung (2) ein erstes Empfangsmittel zur Detektion des zumindest ein zweites elektro-magnetisches Störsignal umfassenden zweiten Empfangssignal (18) umfasst und dazu ausgebildet ist, das zweite Empfangssignal (18) zu detektieren, während das erste Empfangssignal (12) vom EMAT-Empfangswandler detektiert wird, **dadurch gekennzeichnet, dass** die Messanordnung (2) ein zweites Empfangsmittel (44) zur Detektion eines zumindest ein drittes elektro-magnetisches Störsignal umfassenden dritten Empfangssignals umfasst, wobei die Messanordnung (2) dazu ausgebildet ist, zumindest das dritte Empfangssignal mit dem ersten Empfangssignal (12) und dem zweiten Empfangssignal (18) in einer zumindest das erste Empfangssignal (12) zumindest teilweise entstörenden Entstörungsoperation zu verarbeiten.

18. Messanordnung (2) nach Anspruch 17, **dadurch gekennzeichnet, dass** das erste Empfangsmittel eine Empfangsmittel-Induktionsspule (16) umfasst.

19. Messanordnung (2) nach einem der Ansprüche 17 oder 18, **dadurch gekennzeichnet, dass** die Empfangsmittel-Induktionsspule (16) zumindest im Wesentlichen baugleich zur ersten Empfangswandler-Induktionsspule (10a) ausgebildet ist.

20. Messanordnung (2) nach einem der Ansprüche 17 bis 19, **dadurch gekennzeichnet, dass** die Empfangsmittel-Induktionsspule (16) von der ersten Sendewandler-Induktionsspule (6a) oder einer weiteren, von der Empfangswandler-Induktionsspule (10a) verschiedenen Induktionsspule der Messanordnung (2) ausgebildet wird.

21. Messanordnung (2) nach einem der Ansprüche 17 bis 20, **dadurch gekennzeichnet, dass** die Messanordnung (2) eine mit dem Objekt (4) oder einem geerdeten Gehäuseteil eines die Messanordnung schützenden Gehäuses elektrisch leitfähig verbundene oder in sonstiger Weise geerdete Leitung (44) zur Detektion des zweiten Empfangssignals (18) umfasst.

22. Messanordnung nach Anspruch 21, **dadurch gekennzeichnet, dass** die Leitung (44) mit einer Messleitung (46) der Messanordnung unter Beibehaltung einer galvanischen Trennung, insbesondere kapazitiv, signalübertragend verbunden ist.

23. Messanordnung (2) nach einem der Ansprüche 17 bis 22, **dadurch gekennzeichnet, dass** das Entstörungsmittel (22) ein analoges und/oder digitales elektrisches und/oder elektronisches Bauelement, insb. eine Gleichtaktdrossel, oder eine analoge und/oder digitale, elektrische und/oder elektronische Schaltung umfasst.

24. Messanordnung (2) nach einem der Ansprüche 17 bis 23, **dadurch gekennzeichnet, dass** zwischen dem Entstörungsmittel (22) einerseits und dem ersten E-MAT-Empfangswandler (10) und dem ersten Empfangsmittel andererseits eine erste Verstärkerstufe (24) der Messanordnung (2) geschaltet ist.

25. Messanordnung (2) nach einem der Ansprüche 17 bis 24, **dadurch gekennzeichnet, dass** zwischen dem Entstörungsmittel (22) einerseits und zumindest dem ersten EMAT-Empfangswandler (10) und dem ersten Empfangsmittel andererseits eine Explosionsschutz-Barriere (28) (EX-Barriere) der Messanordnung (2) eingerichtet ist.

26. Messanordnung (2) nach einem der Ansprüche 17 bis 25, **dadurch gekennzeichnet, dass** die Messanordnung (2) eine Auswerteeinheit (7) umfasst, wobei die Messanordnung (2) dazu ausgebildet ist, dass mittels der Auswerteeinheit (7) eine Korrelationsanalyse nach einem der Ansprüche 11 bis 14 durchgeführt wird.

27. Messanordnung (2) nach einem der Ansprüche 17 bis 26, **dadurch gekennzeichnet, dass** die Messanordnung (2) einen an oder nahe der Oberfläche des Objekts (4) positionierten zweiten EMAT-Sendewandler (34) umfasst, der eine zumindest eine Leiterbahn aufweisende zweite Sendewandler-Induktionsspule aufweist, zur Erzeugung einer zweiten Ultraschallwelle in dem Objekt (4) und die Messanordnung (2) ferner einen an oder nahe der Oberfläche des Objekts (4) positionierten zweiten EMAT-Empfangswandler (36) umfasst, der eine zumindest eine Leiterbahn aufweisende zweite Empfangswandler-Induktionsspule aufweist, zur Detektion des zweiten Empfangssignals (18), wobei das zweite Empfangssignal (18) zusätzlich zu dem zweiten elektro-magnetisches Störsignal ein sich zumindest teilweise aus der zweiten Ultraschallwelle, die sich durch zumindest einen Teil des Objekts (4) ausgebreitet hat, ergebendes zweites Ultraschallsignal umfasst, wobei die Messanordnung (2) ferner zumindest ein Modulationsmittel (22) umfasst, das die erste Ultraschallwelle (8) mit einem ersten Modulationsmuster und die zweite Ultraschallwelle mit einem zweiten Modulationsmuster moduliert, so dass nach der Detektion eine eindeutige Zuordnung des ersten Ultraschallsignals (14) zur ersten Ultraschallwelle (8) und des zweiten Ultraschallsignals zur zweiten Ultraschallwelle ermöglicht wird, wobei die Messanordnung (2) dazu ausgebildet ist, dass sowohl das erste Empfangssignal (12) als auch das zweite Empfangssignal (18) durch die gemeinsame Verarbeitung in der Entstörungsoperation jeweils zumindest teilweise entstört werden, wobei die Messanordnung (2) ferner zumindest ein Demodulationsmittel (40, 42) umfasst und die Messanordnung (2) dazu ausgebildet ist, dass nach der Entstörungsoperation das erste Ultraschallsignal (14) und das zweite Ultraschallsignal getrennt werden.

## Claims

1. Measurement method on an electrically conductive object (4), wherein a first ultrasound wave (8) is generated in the object (4) by means of a first EMAT transmit transducer (6) of a measurement arrangement (2), which transducer is positioned on or near a surface of the object (4) and has a first transmit transducer induction coil (6a) having at least one conductor path, and a first EMAT receive transducer (10) of the measurement arrangement (2), which transducer is positioned on or near the surface of the object (4) and has a first receive transducer induction coil (10a) having at least one conductor path, detects a first receive signal (12), wherein the first receive signal (12) comprises a first ultrasound signal (14) resulting at least partially from the first ultrasound wave (8) that has propagated through at least a part of the object (4), and a first electromagnetic interference signal, wherein a second receive signal (18) is detected by means of a first receive means of the measurement arrangement (2), while the first receive signal (12) is detected by the first EMAT receive transducer (10), and wherein the second receive signal (18) comprises at least one second electromagnetic interference signal, **characterized in that** at least one third receive signal is detected by means of a second receive means of the measurement arrangement (2), which is different from the first receive means, while the first receive signal (12) is detected by the first EMAT receive transducer (10), wherein the third receive signal is different from the second receive signal (18) and comprises a third electromagnetic interference signal, wherein the third electromagnetic interference signal is a coil interference signal or an earthing interference signal, and at least the third receive signal is processed jointly with the first receive signal (12) and the second receive signal (18) in an interference suppression operation by means of an interference suppression means (22) of the measurement arrangement (2), wherein the interference of at least the first receive signal (12) is at least partially suppressed.

2. Measurement method according to Claim 1, **characterized in that** the second receive signal (18) is detected by a receive means induction coil (16) of the first receive means, which coil is positioned on or near the surface of the object (4) and has at least one conductor path, wherein a coil interference signal is detected as the second interference signal.

3. Measurement method according to Claim 2, **characterized in that** the receive means induction coil (16) used to detect the second receive signal (18) is at least essentially identical in structure to the first receive transducer induction coil (10a).

4. Measurement method according to either of Claims 2 and 3, **characterized in that** the first transmit transducer induction coil (6a) or a further induction coil of the measurement arrangement (2) that is different from the receive transducer induction coil (10a) is used as the receive means induction coil (16) to detect the second receive signal (18).

5. Measurement method according to Claim 1, **characterized in that** the second receive signal (18) is detected by means of a line (44) of the measurement arrangement (2) that is electrically conductively connected to the object (4) or an earthed housing part of a housing protecting the measurement arrangement (2), or is otherwise earthed, as the first receive means, wherein an earthing interference signal is detected as the second interference signal.

6. Measurement method according to Claim 5, **characterized in that** the second receive signal (18) tapped via the line (44) is coupled, in particular capacitively, into a measurement line (46) of the measurement arrangement (2) while maintaining a galvanic isolation.

7. Measurement method according to one of the preceding claims, **characterized in that** at least the first receive signal (12) and the second receive signal (18) are fed to an analogue and/or digital, electrical and/or electronic component or to an analogue and/or digital, electrical and/or electronic circuit as the interference suppression means (22), in particular wherein the interference suppression operation comprises at least a subtraction of the receive signals (12, 18).

8. Measurement method according to one of the preceding claims, **characterized in that** the first receive signal (12) and the second receive signal (18) are fed to a common-mode choke as the interference suppression means (22) and are subjected to an inductive subtraction as the interference suppression operation.

9. Measurement method according to one of the preceding claims, **characterized in that** the first receive signal (12) and the second receive signal (18) pass through a first amplifier stage (24) before they are processed in the interference suppression operation.

10. Measurement method according to one of the preceding claims, **characterized in that** the first receive signal (12) and the second receive signal (18) pass through an explosion protection barrier (28) (EX barrier) of the measurement arrangement (2) that shields a sensor area (26) of the measurement arrangement (2) that comprises at least the first EMAT transmit transducer (6) and the first EMAT receive transducer (10) before they are processed in the interference suppression operation.

11. Measurement method according to one of the preceding claims, **characterized in that** the first receive signal (12) and the second receive signal (18) are subjected to a correlation analysis, in particular before the interference suppression operation, wherein a correlation, in particular an amplitude and/or phase relationship, between the first electromagnetic interference signal and the second electromagnetic interference signal is determined, in particular in the form of corresponding correlation factors.

12. Measurement method according to Claim 11, **characterized in that** a correlation analysis is carried out for at least two different frequencies as a function of the frequency of the first ultrasound wave (8).

13. Measurement method according to one of the preceding claims, **characterized in that** the first electromagnetic interference signal and at least the second electromagnetic interference signal are detected jointly, the first electromagnetic interference signal by means of the first EMAT receive transducer (10) and at least the second electromagnetic interference signal by means of the first receive means, in particular before and/or after the generation and/or the detection of the first ultrasound wave (8), wherein a correlation, in particular an amplitude and/or phase relationship, between the first electromagnetic interference signal and the second electromagnetic interference signal is determined, in particular in the form of corresponding correlation factors.

14. Measurement method according to one of the preceding claims, **characterized in that** the correlation analysis according to one of Claims 11 to 13 is carried out multiple times in succession and weighted correlation factors are determined on the basis of a statistical analysis of correlation factors determined by means of respective correlation analyses.

15. Measurement method according to one of the preceding claims, **characterized in that** a second ultrasound wave is generated in the object (4) by means of a second EMAT transmit transducer (34) of the measurement arrangement (2), which transducer is positioned on or near the surface of the object (4) and has a second transmit transducer induction coil having at least one conductor path, and a second EMAT receive transducer (36) of the measurement arrangement (2), which transducer is positioned on or near the surface of the object and has a second receive transducer induction coil having at least one conductor path, detects the second receive signal (18), wherein, in addition to the second electromagnetic interference signal, the second receive signal (18) comprises a second ultrasound signal resulting at least partially from the second ultrasound wave that has propagated through at least a part of the object (4), wherein the first ultrasound wave (8) is modulated with a first modulation pattern and the second ultrasound wave is modulated with a second modulation pattern so that, following the detection, a unique assignment of the first ultrasound signal (14) to the first ultrasound wave (8) and of the second ultrasound signal to the second ultrasound wave is enabled, wherein the interference of both the first receive signal (12) and the second receive signal (18) is in each case at least partially suppressed by means of the joint processing in the interference suppression operation, wherein, following the interference suppression operation, the first ultrasound signal (14) and the second ultrasound signal are obtained separately by means of a demodulation.

16. Measurement method according to Claim 15, **characterized in that** the modulation patterns used for the modulation are orthogonal to one another.

17. Measurement arrangement (2) for carrying out a measurement method on an electrically conductive object (4) according to one of Claims 1 to 16, having a first EMAT transmit transducer (6) that is positioned on or near a surface of the object (4) and has a first transmit transducer induction coil (6a) having at least one conductor path for generating a first ultrasound wave (8) in the object (4), and having a first EMAT receive transducer (10) that is positioned on or near the surface of the object (4) and has a first receive transducer induction coil (10a) having at least one conductor path for detecting a first receive signal (12), wherein the first receive signal (12) comprises a first ultrasound signal (14) resulting at least partially from the first ultrasound wave (8) that has propagated through at least a part of the object (4) and a first electromagnetic interference signal, wherein the measurement arrangement (2) is designed to detect a second receive signal (18) and comprises an interference suppression means (22), wherein the measurement arrangement (2) is designed to process the first receive signal (12) and the second receive signal (18) by means of the interference suppression means (22) in an interference suppression operation that at least partially suppresses the interference of at least the first receive signal (12), wherein the measurement arrangement (2) comprises a first receive means for detecting the second receive signal (18) comprising at least one second electromagnetic interference signal and is designed to detect the second receive signal (18), while the first receive signal (12) is detected by the EMAT receive transducer, **characterized in that** the measurement arrangement (2) comprises a second receive means (44) for detecting a third receive signal comprising at least one third electromagnetic interference signal, wherein the measurement arrangement (2) is designed to process at least the third receive signal with the first receive signal (12) and the second receive signal (18) in an interference suppression operation that at least partially suppresses the interference of at least the first receive signal (12).

18. Measurement arrangement (2) according to Claim 17, **characterized in that** the first receive means comprises a receive means induction coil (16).

19. Measurement arrangement (2) according to either of Claims 17 and 18, **characterized in that** the receive means induction coil (16) is at least essentially identical in structure to the first receive transducer induction coil (10a).

20. Measurement arrangement (2) according to one of Claims 17 to 19, **characterized in that** the receive means induction coil (16) is formed by the first transmit transducer induction coil (6a) or a further induction coil of the measurement arrangement (2) that is different from the receive transducer induction coil (10a).

21. Measurement arrangement (2) according to one of Claims 17 to 20, **characterized in that** the measurement arrangement (2) comprises a line (44) that is electrically conductively connected to the object (4) or an earthed housing part of a housing protecting the measurement arrangement, or is otherwise earthed, for detecting the second receive signal (18).

22. Measurement arrangement according to Claim 21, **characterized in that** the line (44) is connected to a measurement line (46) of the measurement arrangement by way of a signal-transmitting, in particular capacitive, connection, while maintaining a galvanic isolation.

23. Measurement arrangement (2) according to one of Claims 17 to 22, **characterized in that** the interference suppression means (22) comprises an analogue and/or digital electrical and/or electronic component, in particular a common-mode choke, or an analogue and/or digital, electrical and/or electronic circuit.

24. Measurement arrangement (2) according to one of Claims 17 to 23, **characterized in that** a first amplifier stage (24) of the measurement arrangement (2) is connected between the interference suppression means (22) on the one hand and the first EMAT receive transducer (10) and the first receive means on the other hand.

25. Measurement arrangement (2) according to one of Claims 17 to 24, **characterized in that** an explosion protection barrier (28) (EX barrier) of the measurement arrangement (2) is arranged between the interference suppression means (22) on the one hand and at least the first EMAT receive transducer (10) and the first receive means on the other hand.

26. Measurement arrangement (2) according to one of Claims 17 to 25, **characterized in that** the measurement arrangement (2) comprises an evaluation unit (7), wherein the measurement arrangement (2) is designed in such a way that a correlation analysis according to one of Claims 11 to 14 is carried out by means of the evaluation unit (7).

27. Measurement arrangement (2) according to one of Claims 17 to 26, **characterized in that** the measurement arrangement (2) comprises a second EMAT transmit transducer (34) that is positioned on or near the surface of the object (4) and that has a second transmit transducer induction coil having at least one conductor path for generating a second ultrasound wave in the object (4), and the measurement arrangement (2) further comprises a second EMAT receive transducer (36) that is positioned on or near the surface of the object (4) and that has a second receive transducer induction coil having at least one conductor path for detecting the second receive signal (18), wherein, in addition to the second electromagnetic interference signal, the second receive signal (18) comprises a second ultrasound signal resulting at least partially from the second ultrasound wave that has propagated through at least a part of the object (4), wherein the measurement arrangement (2) further comprises at least one modulation means (22) that modulates the first ultrasound wave (8) with a first modulation pattern and the second ultrasound wave with a second modulation pattern so that, following the detection, a unique assignment of the first ultrasound signal (14) to the first ultrasound wave (8) and of the second ultrasound signal to the second ultrasound wave is enabled, wherein the measurement arrangement (2) is designed in such a way that the interference of both the first receive signal (12) and the second receive signal (18) is in each case at least partially suppressed by the joint processing in the interference suppression operation, wherein the measurement arrangement (2) further comprises at least one demodulation means (40, 42), and the measurement arrangement (2) is designed in such a way that, following the interference suppression operation, the first ultrasound signal (14) and the second ultrasound signal are separated.

## Revendications

1. Procédé de mesure sur un objet (4) électroconducteur, une première onde ultrasonore (8) étant générée dans l'objet (4) au moyen d'un premier transducteur émetteur EMAT (6) d'un ensemble de mesure (2) positionné sur ou à proximité d'une surface de l'objet (4), qui comporte une première bobine d'induction de transducteur émetteur (6a) comportant au moins une piste conductrice, et un premier transducteur récepteur EMAT (10) de l'ensemble de mesure (2) positionné sur ou à proximité de la surface de l'objet (4), lequel comporte une première bobine d'induction de transducteur récepteur (10a) comportant au moins une piste conductrice, détectant un premier signal de réception (12), le premier signal de réception (12) comprenant un premier signal ultrasonore (14) résultant au moins en partie de la première onde ultrasonore (8), qui s'est propagée à travers au moins une partie de l'objet (4), et un premier signal d'interférence électromagnétique, un deuxième signal de réception (18) étant détecté au moyen d'un premier moyen de réception de l'ensemble de mesure (2), pendant que le premier signal de réception (12) est détecté par le premier transducteur récepteur EMAT (10), et le deuxième signal de réception (18) comprenant au moins un deuxième signal d'interférence électromagnétique, **caractérisé en ce qu'**au moins un troisième signal de réception est détecté au moyen d'un deuxième moyen de réception de l'ensemble de mesure (2), qui est différent du premier moyen de réception, pendant que le premier signal de réception (12) est détecté par le premier transducteur récepteur EMAT (10), le troisième signal de réception étant différent du deuxième signal de réception (18) et comprenant un troisième signal d'interférence électromagnétique, le troisième signal d'interférence électromagnétique étant un signal d'interférence de bobine ou un signal d'interférence de mise à la terre, et au moins le troisième signal de réception conjointement avec le premier signal de réception (12) et le deuxième signal de réception (18) étant traité dans une opération de suppression d'interférences au moyen d'un moyen de suppression d'interférences (22) de l'ensemble de mesure (2), au moins les interférences du premier signal de réception (12) étant au moins en partie supprimées.

2. Procédé de mesure selon la revendication 1, **caractérisé en ce que** le deuxième signal de réception (18) est détecté par une bobine d'induction de moyen de réception (16) du premier moyen de réception positionnée sur ou à proximité de la surface de l'objet (4) et comportant au moins une piste conductrice, un signal d'interférence de bobine étant détecté en tant que deuxième signal d'interférence.

3. Procédé de mesure selon la revendication 2, **caractérisé en ce que** la bobine d'induction de moyen de réception (16) utilisée pour détecter le deuxième signal de réception (18) présente une structure au moins sensiblement identique à la première bobine d'induction de transducteur récepteur (10a).

4. Procédé de mesure selon l'une des revendications 2 ou 3, **caractérisé en ce que** la première bobine d'induction de transducteur émetteur (6a) ou une autre bobine d'induction de l'ensemble de mesure (2) différente de la bobine d'induction de transducteur récepteur (10a) est utilisée comme bobine d'induction de moyen de réception (16) pour détecter le deuxième signal de réception (18).

5. Procédé de mesure selon la revendication 1, **caractérisé en ce que** le deuxième signal de réception (18) est détecté au moyen d'une ligne (44) de l'ensemble de mesure (2) reliée de manière électroconductrice à l'objet (4) ou à une partie de boîtier mise à la terre d'un boîtier protégeant l'ensemble de mesure (2), ou mise à la terre d'une autre manière, en tant que premier moyen de réception, un signal d'interférence de mise à la terre étant détecté en tant que deuxième signal d'interférence.

6. Procédé de mesure selon la revendication 5, **caractérisé en ce que** le deuxième signal de réception (18) prélevé via la ligne (44) est couplé, en particulier de manière capacitive, dans une ligne de mesure (46) de l'ensemble de mesure (2) en maintenant une isolation galvanique.

7. Procédé de mesure selon l'une des revendications précédentes, **caractérisé en ce qu'**au moins le premier signal de réception (12) et le deuxième signal de réception (18) sont amenés à un composant analogique et/ou numérique, électrique et/ou électronique ou à un circuit analogique et/ou numérique, électrique et/ou électronique en tant que moyen de suppression d'interférences (22), l'opération de suppression d'interférences comprenant en particulier au moins une soustraction des signaux de réception (12, 18).

8. Procédé de mesure selon l'une des revendications précédentes, **caractérisé en ce que** le premier signal de réception (12) et le deuxième signal de réception (18) sont amenés à une bobine d'arrêt en mode commun en tant que moyen de suppression d'interférences (22) et sont soumis à une soustraction inductive en tant qu'opération de suppression d'interférences.

9. Procédé de mesure selon l'une des revendications précédentes, **caractérisé en ce que** le premier signal de réception (12) et le deuxième signal de réception (18) traversent un premier étage amplificateur (24) avant qu'ils ne soient traités lors de l'opération de suppression d'interférences.

10. Procédé de mesure selon l'une des revendications précédentes, **caractérisé en ce que** le premier signal de réception (12) et le deuxième signal de réception (18) traversent une barrière de protection anti-explosion (28) (barrière EX) de l'ensemble de mesure (2) isolant une zone de capteur(s) (26) de l'ensemble de mesure (2), qui comprend au moins le premier transducteur émetteur EMAT (6) et le premier transducteur récepteur EMAT (10), avant qu'ils ne soient traités lors de l'opération de suppression d'interférences.

11. Procédé de mesure selon l'une des revendications précédentes, **caractérisé en ce que** le premier signal de réception (12) et le deuxième signal de réception (18) sont soumis à une analyse de corrélation, en particulier avant l'opération de suppression d'interférences, une corrélation, en particulier une relation d'amplitude et/ou de phase, entre le premier signal d'interférence électromagnétique et le deuxième signal d'interférence électromagnétique étant déterminée, en particulier sous la forme de facteurs de corrélation correspondants.

12. Procédé de mesure selon la revendication 11, **caractérisé en ce qu'**une analyse de corrélation est effectuée en fonction de la fréquence de la première onde ultrasonore (8) pour au moins deux fréquences différentes.

13. Procédé de mesure selon l'une des revendications précédentes, **caractérisé en ce que**, en particulier avant et/ou après la génération et/ou la détection de la première onde ultrasonore (8), le premier signal d'interférence électromagnétique au moyen du premier transducteur récepteur EMAT (10) et au moins le deuxième signal d'interférence électromagnétique au moyen du premier moyen de réception sont détectés conjointement, une corrélation, en particulier une relation d'amplitude et/ou de phase, entre le premier signal d'interférence électromagnétique et le deuxième signal d'interférence électromagnétique étant déterminée, en particulier sous la forme de facteurs de corrélation correspondants.

14. Procédé de mesure selon l'une des revendications précédentes, **caractérisé en ce que** l'analyse de corrélation selon l'une des revendications 11 à 13 est effectuée plusieurs fois successivement et des facteurs de corrélation pondérés sont déterminés sur la base d'une analyse statistique de facteurs de corrélation déterminés au moyen d'analyses de corrélation respectives.

15. Procédé de mesure selon l'une des revendications précédentes, **caractérisé en ce qu'**une deuxième onde ultrasonore est générée dans l'objet (4) au moyen d'un deuxième transducteur émetteur EMAT (34) de l'ensemble de mesure (2) positionné sur ou à proximité de la surface de l'objet (4), qui présente une deuxième bobine d'induction de transducteur émetteur comportant au moins une piste conductrice, et un deuxième transducteur récepteur EMAT (36) de l'ensemble de mesure (2) positionné sur ou à proximité de la surface de l'objet, qui comporte une deuxième bobine d'induction de transducteur récepteur comportant au moins une piste conductrice, détecte le deuxième signal de réception (18), le deuxième signal de réception (18) comprenant, en plus du deuxième signal d'interférence électromagnétique, un deuxième signal ultrasonore résultant au moins en partie de la deuxième onde ultrasonore, qui s'est propagée à travers au moins une partie de l'objet (4), la première onde ultrasonore (8) étant modulée avec un premier motif de modulation et la deuxième onde ultrasonore étant modulée avec un deuxième motif de modulation, de telle sorte que, après la détection, une association univoque du premier signal ultrasonore (14) à la première onde ultrasonore (8) et du deuxième signal ultrasonore à la deuxième onde ultrasonore est rendue possible, les interférences à la fois du premier signal de réception (12) et du deuxième signal de réception (18) étant supprimées au moins en partie par le traitement commun dans l'opération de suppression d'interférences, le premier signal ultrasonore (14) et le deuxième signal ultrasonore étant obtenus séparément par une démodulation après l'opération de suppression d'interférences.

16. Procédé de mesure selon la revendication 15, **caractérisé en ce que** les motifs de modulation utilisés pour la modulation sont orthogonaux les uns par rapport aux autres.

17. Ensemble de mesure (2) destiné à effectuer un procédé de mesure sur un objet (4) électroconducteur selon l'une des revendications 1 à 16, avec un premier transducteur émetteur EMAT (6) positionné sur ou à proximité d'une surface de l'objet (4), qui comporte une première bobine d'induction de transducteur émetteur (6a) comportant au moins une piste conductrice, pour générer une première onde ultrasonore (8) dans l'objet (4) et avec un premier transducteur récepteur EMAT (10) positionné sur ou à proximité de la surface de l'objet (4), qui comporte une première bobine d'induction de transducteur récepteur (10a) comportant au moins une piste conductrice, pour détecter un premier signal de réception (12), le premier signal de réception (12) comprenant un premier signal ultrasonore (14) résultant au moins en partie de la première onde ultrasonore (8), qui s'est propagée à travers au moins une partie de l'objet (4), et un premier signal d'interférence électromagnétique, l'ensemble de mesure (2) étant conçu pour détecter un deuxième signal de réception (18), et comprenant un moyen de suppression d'interférences (22), l'ensemble de mesure (2) étant conçu pour traiter le premier signal de réception (12) et le deuxième signal de réception (18) au moyen du moyen de suppression d'interférences (22) dans une opération de suppression d'interférences supprimant au moins en partie les interférences au moins du premier signal de réception (12), l'ensemble de mesure (2) comprenant un premier moyen de réception pour détecter le deuxième signal de réception (18) comprenant au moins un deuxième signal d'interférence électromagnétique et étant conçu pour détecter le deuxième signal de réception (18), pendant que le premier signal de réception (12) est détecté par le transducteur récepteur EMAT, **caractérisé en ce que** l'ensemble de mesure (2) comprend un deuxième moyen de réception (44) pour détecter un troisième signal de réception comprenant au moins un troisième signal d'interférence électromagnétique, l'ensemble de mesure (2) étant conçu pour traiter au moins le troisième signal de réception avec le premier signal de réception (12) et le deuxième signal de réception (18) dans une opération de suppression d'interférences supprimant au moins en partie les interférences au moins du premier signal de réception (12).

18. Ensemble de mesure (2) selon la revendication 17, **caractérisé en ce que** le premier moyen de réception comprend une bobine d'induction de moyen de réception (16).

19. Ensemble de mesure (2) selon l'une des revendications 17 ou 18, **caractérisé en ce que** la bobine d'induction de moyen de réception (16) présente une structure au moins sensiblement identique à la première bobine d'induction de transducteur récepteur (10a).

20. Ensemble de mesure (2) selon l'une des revendications 17 à 19, **caractérisé en ce que** la bobine d'induction de moyen de réception (16) est formée par la première bobine d'induction de transducteur émetteur (6a) ou par une autre bobine d'induction de l'ensemble de mesure (2) différente de la bobine d'induction de transducteur récepteur (10a).

21. Ensemble de mesure (2) selon l'une des revendications 17 à 20, **caractérisé en ce que** l'ensemble de mesure (2) comprend une ligne (44) raccordée de manière électroconductrice à l'objet (4) ou à une partie de boîtier mise à la terre d'un boîtier protégeant l'ensemble de mesure ou autrement mise à la terre pour la détection du deuxième signal de réception (18).

22. Ensemble de mesure selon la revendication 21, **caractérisé en ce que** la ligne (44) est reliée de manière à transmettre des signaux, en particulier de manière capacitive, à une ligne de mesure (46) de l'ensemble de mesure tout en maintenant une isolation galvanique.

23. Ensemble de mesure (2) selon l'une des revendications 17 à 22, **caractérisé en ce que** le moyen de suppression d'interférences (22) comprend un composant analogique et/ou numérique, électrique et/ou électronique, en particulier une bobine d'arrêt en mode commun, ou un circuit analogique et/ou numérique, électrique et/ou électronique.

24. Ensemble de mesure (2) selon l'une des revendications 17 à 23, **caractérisé en ce qu'**un premier étage amplificateur (24) de l'ensemble de mesure (2) est monté entre le moyen de suppression d'interférences (22) d'une part et le premier transducteur récepteur EMAT (10) et le premier moyen de réception d'autre part.

25. Ensemble de mesure (2) selon l'une des revendications 17 à 24, **caractérisé en ce qu'**une barrière de protection anti-explosion (28) (barrière EX) de l'ensemble de mesure (2) est agencée entre le moyen de suppression d'interférences (22) d'une part et au moins le premier transducteur récepteur EMAT (10) et le premier moyen de réception d'autre part.

26. Ensemble de mesure (2) selon l'une des revendications 17 à 25, **caractérisé en ce que** l'ensemble de mesure (2) comprend une unité d'évaluation (7), l'ensemble de mesure (2) étant conçu pour qu'une analyse de corrélation selon l'une des revendications 11 à 14 soit effectuée au moyen de l'unité d'évaluation (7).

27. Ensemble de mesure (2) selon l'une des revendications 17 à 26, **caractérisé en ce que** l'ensemble de mesure (2) comprend un deuxième transducteur émetteur EMAT (34) positionné sur ou à proximité de la surface de l'objet (4), qui comporte une deuxième bobine d'induction de transducteur émetteur comportant au moins une piste conductrice, pour générer une deuxième onde ultrasonore dans l'objet (4) et l'ensemble de mesure (2) comprend en outre un deuxième transducteur récepteur EMAT (36) positionné sur ou à proximité de la surface de l'objet (4), qui comporte une deuxième bobine d'induction de transducteur récepteur comportant au moins une piste conductrice, pour détecter le deuxième signal de réception (18), le deuxième signal de réception (18) comprenant, en plus du deuxième signal d'interférence électromagnétique, un deuxième signal ultrasonore résultant au moins en partie de la deuxième onde ultrasonore, qui s'est propagée à travers au moins une partie de l'objet (4), l'ensemble de mesure (2) comprenant en outre au moins un moyen de modulation (22), qui module la première onde ultrasonore (8) avec un premier motif de modulation et la deuxième onde ultrasonore avec un deuxième motif de modulation de telle sorte que, après la détection, une association univoque du premier signal ultrasonore (14) à la première onde ultrasonore (8) et du deuxième signal ultrasonore à la deuxième onde ultrasonore est rendue possible, l'ensemble de mesure (2) étant conçu pour que les interférences à la fois du premier signal de réception (12) et du deuxième signal de réception (18) soient au moins en partie supprimées par le traitement commun dans l'opération de suppression d'interférences, l'ensemble de mesure (2) comprenant en outre au moins un moyen de démodulation (40, 42) et l'ensemble de mesure (2) étant conçu pour que le premier signal ultrasonore (14) et le deuxième signal ultrasonore soient séparés après l'opération de suppression d'interférences.
